# EUROPEAN PATENT SPECIFICATION

(11) **EP 3 893 616 B1**
(45) Date of publication and mention of the grant of the patent: **28.06.2023**
(21) Application number: 19918778.2
(22) Date of filing: 23.12.2019
(51) Int. Cl.: H05K 7/20

(54) **CABINET AND FLEXIBLE AIR DUCT SYSTEM**
SCHRANK UND FLEXIBLES LUFTKANALSYSTEM
ARMOIRE ET SYSTÈME DE CONDUIT D'AIR FLEXIBLE

(30) Priority: 12.03.2019 CN 201910186063
(43) Date of publication of application: 13.10.2021
(73) Proprietor: Huawei Digital Power Technologies Co., Ltd., Shenzhen, 518043 (CN)
(72) Inventor: YANG, Zekai, Shenzhen, Guangdong 518129 (CN); CHEN, Rui, Shenzhen, Guangdong 518129 (CN); QIU, Yongqi, Shenzhen, Guangdong 518129 (CN)
(74) Representative: Pfenning, Meinig & Partner mbB
(86) International application number: PCT/CN2019/127559
(87) International publication number: WO 2020/181876

(56) References cited:
- US-A1- 2013 026 404
- US-A1- 2014 104 783
- US-B2- 7 112 131

## Description

### TECHNICAL FIELD

This application relates to a cabinet.

### BACKGROUND

Document US 7 112 131 B2 describes an air distribution unit for use in a rack that holds rack-mounted equipment, the air distribution unit comprising: a housing defining an interior chamber, at least one intake vent defined in a front panel of the housing and configured to provide fluid communication between the interior chamber and an area external to the housing, and at least one exhaust vent defined in a side panel of the housing, the housing being configured to be disposed in the rack and to direct air from the interior chamber substantially laterally through the at least one exhaust vent when coupled to the rack; and at least one fan coupled to and disposed within the housing parallel to a top panel and a bottom panel of the housing and configured to draw air from the area external to the housing through the at least one intake vent, and to force the drawn-in air out of the air distribution unit through the at least one exhaust vent.
Document US 2013/026404 A1 describes an air partition member for guiding air flow generated by fans in different servers.
Document US 2014/104783 A1 describes an electronic device with an air guiding apparatus for guiding airflow.

A cabinet is used to install various devices. Common cabinets include power cabinets and equipment cabinets. To ensure a proper temperature for devices in the cabinets, the power cabinets and equipment cabinets each have an independent heat dissipation system. The heat dissipation system dissipates heat from devices in the cabinet, to prevent overtemperature of the devices, thereby ensuring the operating performance. The distribution of air ducts in the heat dissipation system greatly affects heat dissipation of the cabinet.

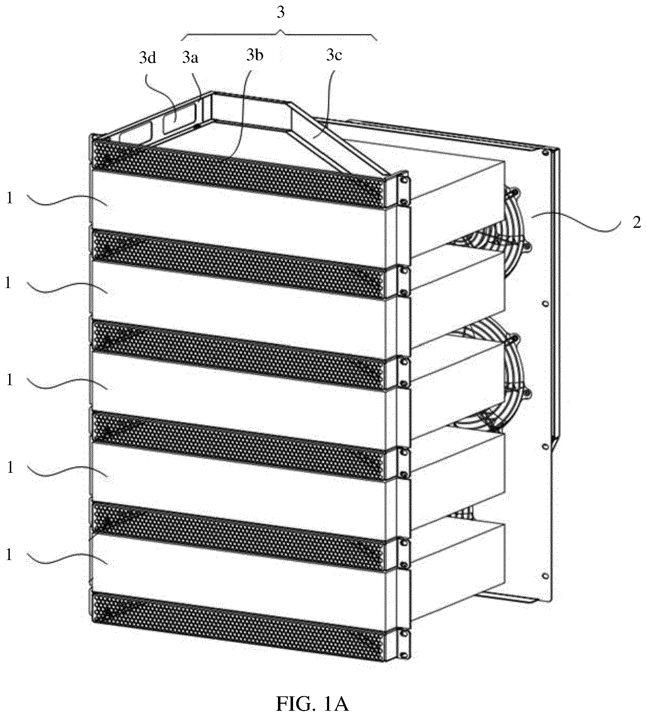

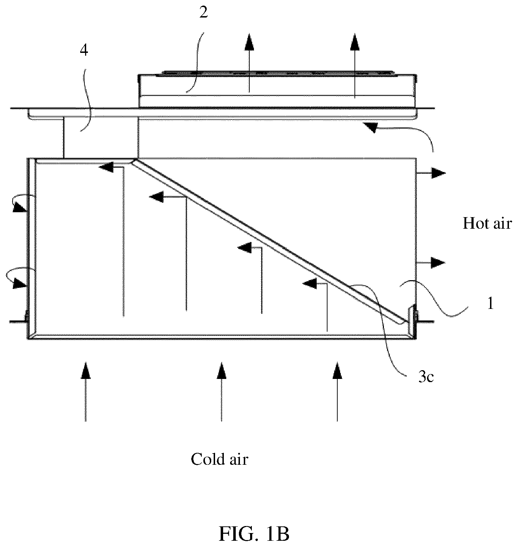

FIG. 1A and FIG. 1B show air ducts in a cabinet. The air duct system includes a plurality of air duct enclosures 3 and a fan assembly 2. The plurality of air duct enclosures 3 and devices 1 are alternately installed in the cabinet. In other words, two adjacent devices are separated by an air duct enclosure 3. The fan assembly 2 is installed behind the devices 1. Air flows enter from an air intake vent provided on a front panel 3b of the air duct enclosure 3; exit, under an action of an air deflection panel 3c of the air duct enclosure 3, from an air exhaust vent 3d provided on a side panel 3a of the air duct enclosure; and enter the device 1 from a left side of the device 1. Hot air passes through the device 1, and is then blown out from a right side of the device 1 into a rear part of the cabinet and exhausted to the outside of the cabinet by the fan assembly 2. In addition, windproof cotton padding 4 is installed on the fan assembly 2, and the windproof cotton padding 4 is attached to a rear part of the device 1 to isolate the cool air and the hot air.

However, in the foregoing air duct system, the air duct enclosures and the devices have the same depth. As a result, only devices of the same dimension as the air duct enclosures can be disposed in the cabinet in use. If devices of other depth dimensions are disposed, these devices do not match the air duct enclosures, resulting in unsatisfactory heat dissipation. In other words, the conventional-technology air duct system in the cabinet cannot accommodate devices of other depth dimensions. Consequently, the cabinet cannot accommodate devices of different depths.

### SUMMARY

This application provides a cabinet according to claim 1, to accommodate devices of different depths and devices having different air intake modes. This expands the applicable scope of the cabinet and resolves the problem that a conventional-technology cabinet cannot accommodate devices of different depths and devices having different air intake modes.

This application provides a cabinet, including a cabinet body and at least one device disposed in the cabinet body, where
the cabinet body is further provided with at least one air duct system, and the air duct system includes:
a plurality of air deflection parts and an air baffle that is scalable along an insertion direction of the device, where one end of the air baffle is connected to an inner wall of the cabinet body, and the other end of the air baffle presses against the device; the plurality of air deflection parts are disposed along the air baffle in the cabinet body, wherein an interval exists between two adjacent air deflection parts; and when the device is inserted into a spacing, the plurality of air deflection parts and the air baffle divide inner space of the cabinet body into a cold air duct and a hot air duct that are isolated from each other. Further, the interval and the spacing coincide. Additionally, an air intake vent of the device and an inner wall that is of the cabinet body and on which an air intake vent is provided are both located in the cold air duct; an air exhaust vent of the device and an inner wall that is of the cabinet body and on which an air exhaust vent is provided are both located in the hot air duct; one side of the plurality of air deflection parts, one side of the air baffle, and some inner walls of the cabinet body enclose to form the cold air duct; and the other side of the plurality of air deflection parts, the other side of the air baffle, and remaining inner walls of the cabinet body enclose to form the hot air duct. Moreover, each air deflection part is an air deflection part with an adjustable length; and one end of each air deflection part is connected to the air baffle, and the other end of each air deflection part is connected to an inner wall of the cabinet body; or a guide rail is disposed at one end of the air baffle that faces the device, both sides of the guide rail are provided with a sliding slot for the air deflection part to pass through, one end of the air deflection part is connected to an inner wall of the cabinet body, the other end of the air deflection part passes through one of the sliding slots and extends to the end of the air baffle that is connected to the cabinet body, and the guide rail slides on the air deflection part when the air baffle is compressed.

In the cabinet provided in this application, the air duct system includes the plurality of air deflection parts and the air baffle that is scalable along the insertion direction of the device, where one end of the air baffle is connected to an inner wall of the cabinet body, and the other end of the air baffle presses against the device; the plurality of air deflection parts are alternately disposed along the air baffle in the cabinet body; and when the device is inserted into a spacing, the plurality of air deflection parts and the air baffle divide the inner space of the cabinet body into the cold air duct and the hot air duct that are isolated from each other, thereby forming a flexible air duct. When devices of different depths are inserted into a spacings, the air baffle in the air duct system can be scaled, so that the flexible air duct can accommodate devices of different depths. In this way, the cabinet is not limited to accommodating only devices of one depth, but can accommodate of devices of different depths. Moreover, the air deflection parts are independent components, and positions of the air deflection parts can be adjusted based on air intake modes of the devices, so that the cabinet can accommodate devices having different air intake modes, thereby expanding an applicable scope of the cabinet and greatly improving a degree of integration and competitiveness of the cabinet. In addition, the air duct system is a flexible air duct. In this way, positions of the air baffle and the air deflection parts do not need to be changed during replacement of devices of different depths in the cabinet, facilitating replacement and reducing the difficulty in replacing devices onsite. Therefore, the cabinet provided in this embodiment can accommodate devices of different depths and devices having different air intake modes. This reduces the difficulty in replacing devices onsite and resolves the problem that a conventional-technology cabinet cannot accommodate devices of different depths and devices having different air intake modes.

In a possible implementation of the first aspect, the air deflection part is made of an elastic material, so that the length of the air deflection part is adjustable.

In a possible implementation of the first aspect, the air deflection part includes at least two air deflection panels that are slidably connected to each other, one end of the air deflection part is rotatably connected to the air baffle, and the other end of the air deflection part is connected to the inner wall of the cabinet body.

In a possible implementation of the first aspect, the air deflection part includes a first air deflection panel and a second air deflection panel, one end of the first air deflection panel is rotatably connected to the air baffle, the other end of the first air deflection panel is slidably connected to one end of the second air deflection panel, and the other end of the second air deflection panel is connected to the inner wall of the cabinet body.

In a possible implementation of the first aspect, the air deflection part is rotatably connected to the air baffle by using a rotating shaft, a hinge, or a flexible material.

In a possible implementation of the first aspect, the cabinet further includes an elastic part, where the elastic part is connected to the air baffle, and the elastic part is configured to drive the compressed air baffle to stretch out.

In a possible implementation of the first aspect, the air baffle includes at least two sub air baffles, and space between two adjacent sub air baffles is sealed.

In a possible implementation of the first aspect, a rotatable fastening portion is provided at the end of the air deflection part that is connected to the inner wall of the cabinet body, and the fastening portion is configured to connect the other end of the air deflection part to the cabinet body.

In a possible implementation of the first aspect, at least two mounting bars are further provided in the cabinet body, and the mounting bars are configured to connect the fastening portion to the cabinet body.

In a possible implementation of the first aspect, the cabinet further includes a bracket, where the air baffle is connected to the inner wall of the cabinet body by using the bracket.

In a possible implementation of the first aspect, the bracket includes a plurality of U-shaped enclosures, and the plurality of U-shaped enclosures are connected to the air baffle in a spaced manner.

In a possible implementation of the first aspect, the air baffle is disposed vertically in the cabinet body, so that the device is arranged laterally in the cabinet body, or
the air baffle is disposed horizontally in the cabinet body, so that the device is arranged vertically in the cabinet body

In a possible implementation of the first aspect, a material of the air baffle is any of the following materials:
sponge, a flexible material, an elastic material, or a structure formed by a combination of an elastic material and a metallic or nonmetallic material.

An example provides a flexible air duct system, disposed in a cabinet. The flexible air duct system includes:
a plurality of air deflection parts and an air baffle that is scalable along an insertion direction of a device in the cabinet, where one end of the air baffle is connected to an inner wall of a cabinet body of the cabinet, and the other end of the air baffle presses against the device; the plurality of air deflection parts are disposed along the air baffle in the cabinet body, wherein an interval exists between two adjacent air deflection parts; and when the device is inserted into a spacing, the plurality of air deflection parts and the air baffle divide inner space of the cabinet body into a cold air duct and a hot air duct that are isolated from each other. Further, the interval and the spacing coincide. Additionally, an air intake vent of the device and an inner wall that is of the cabinet body and on which an air intake vent is provided are both located in the cold air duct; an air exhaust vent of the device and an inner wall that is of the cabinet body and on which an air exhaust vent is provided are both located in the hot air duct; one side of the plurality of air deflection parts, one side of the air baffle, and some inner walls of the cabinet body enclose to form the cold air duct; and the other side of the plurality of air deflection parts, the other side of the air baffle, and remaining inner walls of the cabinet body enclose to form the hot air duct. Moreover, each air deflection
part is an air deflection part with an adjustable length; and one end of each air deflection part is connected to the air baffle, and the other end of each air deflection part is connected to an inner wall of the cabinet body; or a guide rail is disposed at one end of the air baffle that faces the device, both sides of the guide rail are provided with a sliding slot for the air deflection part to pass through, one end of the air deflection part is connected to an inner wall of the cabinet body, the other end of the air deflection part passes through one of the sliding slots and extends to the end of the air baffle that is connected to the cabinet body, and the guide rail slides on the air deflection part when the air baffle is compressed.

The flexible air duct system includes the plurality of air deflection parts and the air baffle that is scalable along the insertion direction of the device, where one end of the air baffle is connected to an inner wall of the cabinet body, and the other end of the air baffle presses against the device; the plurality of air deflection parts are alternately disposed along the air baffle in the cabinet body; and when the device is inserted into a spacing, the plurality of air deflection parts and the air baffle divide the inner space of the cabinet body into the cold air duct and the hot air duct that are isolated from each other, thereby forming a flexible air duct. When devices of different depths are inserted into a spacings, the air baffle in the air duct system can be scaled, so that the flexible air duct can accommodate devices of different depths. In this way, the cabinet is not limited to accommodating only devices of one depth, but can accommodate of devices of different depths. Moreover, the air deflection parts are independent components, and positions of the air deflection parts can be adjusted based on air intake modes of the devices, so that the cabinet can accommodate devices having different air intake modes, thereby expanding an applicable scope of the cabinet and greatly improving a degree of integration and competitiveness of the cabinet. In addition, the air duct system is a flexible air duct. In this way, positions of the air baffle and the air deflection parts do not need to be changed during replacement of devices of different depths in the cabinet, facilitating replacement and reducing the difficulty in replacing devices onsite. Therefore, the cabinet provided in this embodiment can accommodate devices of different depths and devices having different air intake modes. This reduces the difficulty in replacing devices onsite and resolves the problem that a conventional-technology cabinet cannot accommodate devices of different depths and devices having different air intake modes.

In a possible implementation of the second aspect, the air deflection part is made of an elastic material, so that the length of the air deflection part is adjustable.

In a possible implementation of the second aspect, the air deflection part includes at least two air deflection panels that are slidably connected to each other, one end of the air deflection part is rotatably connected to the air baffle, and the other end of the air deflection part is connected to the inner wall of the cabinet body.

In a possible implementation of the second aspect, the air deflection part includes a first air deflection panel and a second air deflection panel, one end of the first air deflection panel is rotatably connected to the air baffle, the other end of the first air deflection panel is slidably connected to one end of the second air deflection panel, and the other end of the second air deflection panel is connected to the inner wall of the cabinet body.

In a possible implementation of the second aspect, the air deflection part is rotatably connected to the air baffle by using a rotating shaft, a hinge, or a flexible material.

In a possible implementation of the second aspect, the flexible air duct system further includes an elastic part, where the elastic part is connected to the air baffle, and the elastic part is configured to drive the compressed air baffle to stretch out.

In a possible implementation of the second aspect, the air baffle includes at least two sub air baffles, and space between two adjacent sub air baffles is sealed.

In a possible implementation of the second aspect, a rotatable fastening portion is provided at the end of the air deflection part that is connected to the inner wall of the cabinet body, and the fastening portion is configured to connect the other end of the air deflection part to the cabinet body.

In a possible implementation of the second aspect, the flexible air duct system further includes a bracket, where the air baffle is connected to the inner wall of the cabinet body by using the bracket.

In a possible implementation of the second aspect, the bracket includes a plurality of U-shaped enclosures, and the plurality of U-shaped enclosures are connected to the air baffle in a spaced manner.

In a possible implementation of the second aspect, a material of the air baffle is any of the following materials:
sponge, a flexible material, an elastic material, or a structure formed by a combination of an elastic material and a metallic or nonmetallic material.

These and other aspects, implementations, and advantages of the example embodiments will become evident with reference to the accompanying drawings and based on the embodiments described below. However, it should be understood that the specification and accompanying drawings are only intended for illustrative purposes and do not serve as definitions that limit this application. Details are described in the appended claims. Other aspects and advantages of this application will be described in the following descriptions. Some aspects and advantages will become evident in the descriptions or learned of through practice of this application. In addition, the aspects and advantages of this application can be achieved and obtained by using the means particularly specified in the appended claims or a combination thereof.

### BRIEF DESCRIPTION OF DRAWINGS

FIG. 1A is a 3D schematic structural diagram of an air duct system and devices in a conventional-technology cabinet;
FIG. 1B is a top-view schematic structural diagram of an air duct system and devices in a conventional-technology cabinet;
FIG. 2A is a schematic diagram of an internal structure of a cabinet according to Embodiment 1 of this application when a door on the cabinet is opened;
FIG. 2B is a 3D structural diagram of an air duct system in a cabinet according to Embodiment 1 of this application;
FIG. 2C is a top-view schematic structural diagram of an air duct system and a device with a left air intake vent in a cabinet according to Embodiment 1 of this application;
FIG. 2D is a top-view schematic structural diagram of an air duct system and another device with a left air intake vent in a cabinet according to Embodiment 1 of this application;
FIG. 2E is a top-view schematic structural diagram of an air duct system and a device with a right air intake vent in a cabinet according to Embodiment 1 of this application;
FIG. 2F is another top-view schematic structural diagram of an air duct system and a device with a left air intake vent in a cabinet according to Embodiment 1 of this application;
FIG. 2G is another top-view schematic structural diagram of an air duct system and a device with a right air intake vent in a cabinet according to Embodiment 1 of this application;
FIG. 2H is still another top-view schematic structural diagram of an air duct system and another device with a left air intake vent in a cabinet according to Embodiment 1 of this application;
FIG. 3A is a side-view schematic structural diagram of an air duct system in a cabinet according to Embodiment 2 of this application;
FIG. 3B is a side-view schematic structural diagram of an air duct system into which devices of different depths are inserted in a cabinet according to Embodiment 2 of this application; and
FIG. 4 is a schematic structural diagram of an air duct system in a cabinet according to Embodiment 3 of this application.

### Reference numerals:

10 - cabinet body; 11 - cabinet door; 20 - air duct system; 21 - air baffle; 211 - guide rail; 21a and 21b - sub air baffles; 22 - air deflection part; 221 - fastening portion; 23 - bracket; 23a - U-shaped enclosure; 201 - cold air duct; 202 - hot air duct; 30, 30a, 30b, and 30c - devices; and 40 - mounting bar.

### DESCRIPTION OF EMBODIMENTS

### Embodiment 1

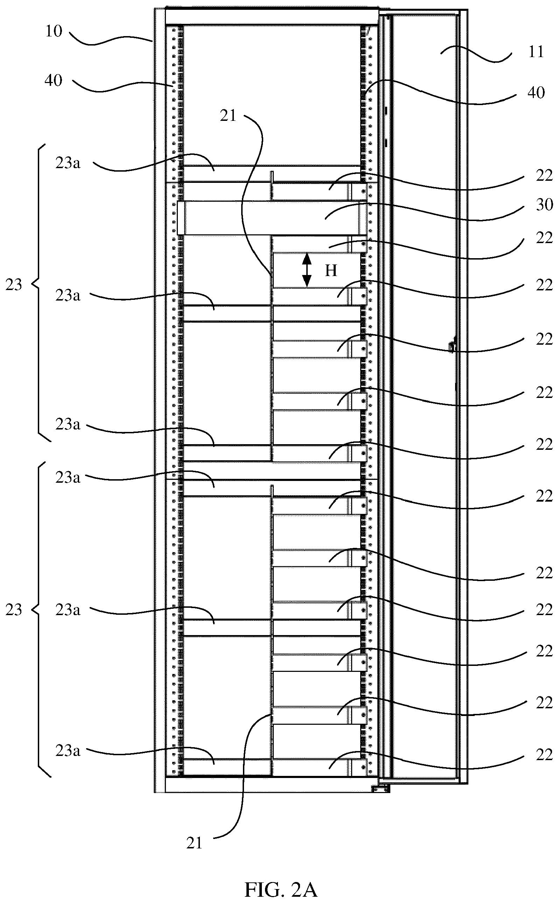

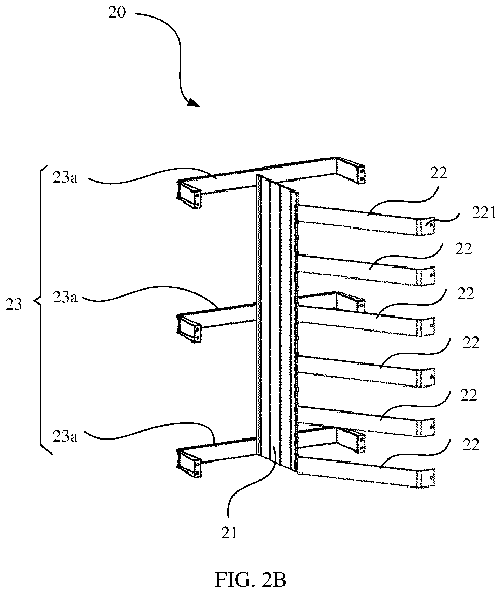

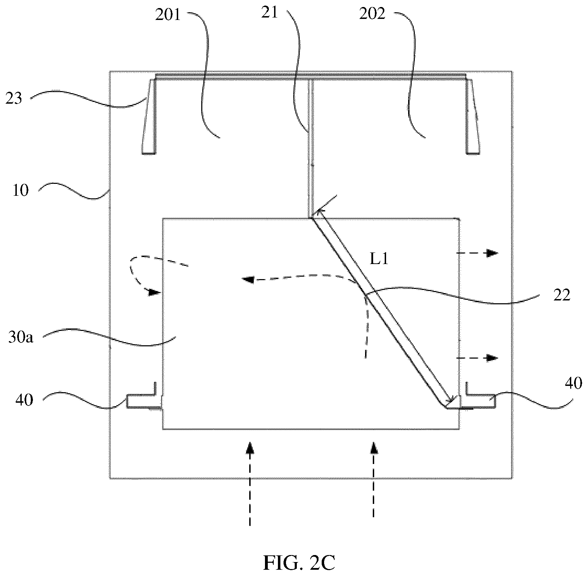

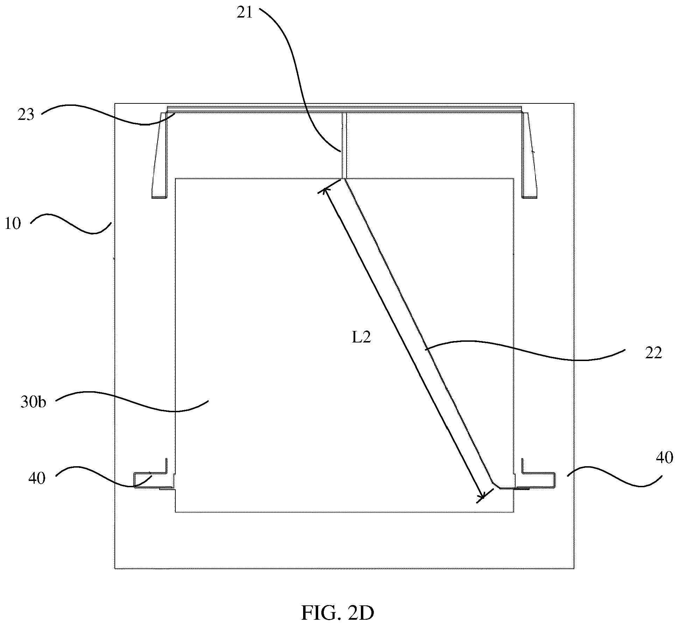

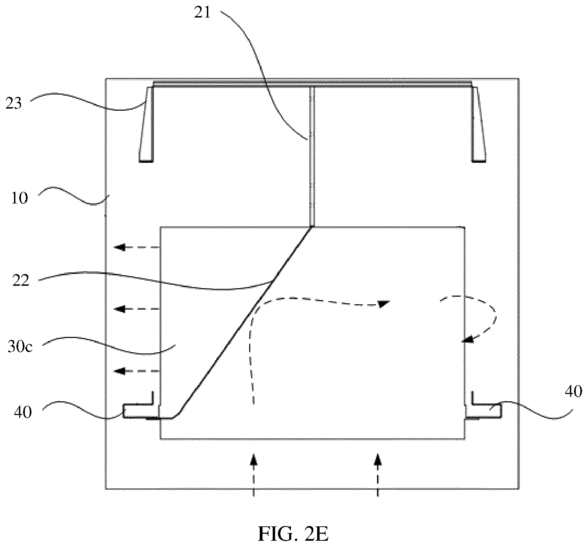

FIG. 2A is a schematic diagram of an internal structure of a cabinet according to Embodiment 1 of this application when a door on the cabinet is opened. FIG. 2B is a 3D structural diagram of an air duct system in the cabinet according to Embodiment 1 of this application. FIG. 2C is a top-view schematic structural diagram of the air duct system and a device with a left air intake vent in the cabinet according to Embodiment 1 of this application. FIG. 2D is a top-view schematic structural diagram of the air duct system and another device with a left air intake vent in the cabinet according to Embodiment 1 of this application. FIG. 2E is a top-view schematic structural diagram of the air duct system and a device with a right air intake vent in the cabinet according to Embodiment 1 of this application.

As described in the BACKGROUND section, a conventional-technology cabinet cannot accommodate devices of different depths. This problem is caused because an air duct enclosure in an air duct system of the conventional-technology cabinet is of the same depth as a device. If a device of another depth dimension is installed in the cabinet, the device does not match the air duct enclosure in the cabinet. Consequently, a cold channel and a hot channel are connected, resulting in unsatisfactory heat dissipation of the device. In other words, the air duct system in the cabinet cannot accommodate devices of other depth dimensions, so that the conventional-technology cabinet can accommodate only devices of one depth and cannot accommodate devices of different depths.

Therefore, to resolve the foregoing problem, in this embodiment, as shown in FIG. 2A to FIG. 2E, the cabinet includes a cabinet body 10 and at least one device 30 that is disposed in the cabinet body 10. A quantity of devices 30 is specifically set based on an actual need. A cabinet door 11 is disposed on the cabinet body 10. In this embodiment, the cabinet body 10 is further provided with an air duct system 20. The air duct system 20 includes a plurality of air deflection parts 22 and an air baffle 21 that is scalable along an insertion direction of the device 30. To be specific, in this embodiment, to accommodate devices 30 of different depths, the air baffle 21 is scalable, and the air baffle 21 is specifically scalable along the insertion direction of the device 30. For example, as shown in FIG. 2C, when a device 30 in the cabinet is inserted from front to back, the air baffle 21 is scalable in a front-back direction. In this way, when a device 30b in the cabinet is of a relatively large depth, as shown in FIG. 2D, the air baffle 21 is compressed in the front-back direction. Therefore, in this embodiment, an air duct formed in the cabinet is a flexible air duct. When the devices 30 installed in the cabinet are of different depths, the air baffle 21 in the air duct system 20 can be scaled, so that the air duct system 20 can meet the devices 30 of different depths. In this way, the devices 30 installed in the cabinet are not limited to devices 30 of one depth, and devices 30 of other depths can also be installed. In other words, the cabinet provided in this embodiment can accommodate devices 30 of different depths, including both devices 30 of large depths and devices 30 of shallow depths. In addition, positions of the air deflection parts 22 can be adjusted based on devices having different air intake modes, so that the cabinet can accommodate devices having different air intake modes, thereby expanding an applicable scope of the cabinet and greatly improving a degree of integration and competitiveness of the cabinet. Moreover, the air baffle 21 in the air duct system 20 is scalable. In this way, positions of the air baffle 21 and the air deflection parts 22 do not need to be changed during replacement of devices 30 of different depths in the cabinet, facilitating replacement and reducing the difficulty in replacing devices 30 onsite.

In this embodiment, one end of the air baffle 21 is connected to an inner wall of the cabinet body 10, and the other end of the air baffle 21 presses against the device 30. The plurality of air deflection parts 22 are alternately disposed along the air baffle 21 in the cabinet body 10. An interval H exists between two adjacent air deflection parts 22. The device 30 is inserted into a spacing H during installation. However, it should be noted that when the device 30 is inserted into a spacing between the air deflection parts 22, space between the air deflection parts 22 and the device 30 needs to be sealed, to ensure that air ducts on two sides of an air deflection part 22 are isolated and separated from each other. In this embodiment, as shown in FIG. 2B, the air baffle 21 includes two long edges that are opposite to each other and two short edges that are opposite to each other. One of the long edges of the air baffle 21 is connected to the inner wall of the cabinet body 10, and the plurality of air deflection parts 22 are alternately disposed along the other long edge of the air baffle 21.

In addition, in this embodiment, when the device 30 is inserted into a spacing H between the air deflection parts 22, the plurality of air deflection parts 22 and the air baffle 21 divide inner space of the cabinet body 10 into a cold air duct 201 and a hot air duct 202 that are isolated from each other. To be specific, an internal cavity of the cabinet body 10 is divided into two air ducts. One of the air ducts is enclosed by one side of the plurality of air deflection parts 22, one side of the air baffle 21, and some inner walls of the cabinet body 10; and the other air duct is enclosed by the other side of the plurality of air deflection parts 22, the other side of the air baffle 21, and remaining inner walls of the cabinet body 10. An air intake vent on the cabinet body 10 leads to the cold air duct 201, and an air exhaust vent on the cabinet body 10 leads to the hot air duct 202. After the device 30 is installed, a part of the device 30 is located in the cold air duct 201, and the other part of the device 30 is located in the hot air duct 202. An end that is of the device 30 and on which an air intake vent is provided needs to be located in the cold air duct 201, and an end that is of the device 30 and on which an air exhaust vent is provided needs to be located in the hot air duct 202. After cold air enters the cold air duct 201, the cold air is guided to the air intake vent of the device 30 by the air deflection parts 22, and is discharged into the hot air duct 202 through the air exhaust vent of the device 30 after passing through the device 30. The hot air duct 202 is connected to the air exhaust vent on the cabinet body 10. Finally, hot air is discharged to the outside through the air exhaust vent on the cabinet body 10. Specifically, as shown in FIG. 2C, an air intake mode of the device 30 is left-in, right-out. In this case, the air deflection parts 22 and the air baffle 21 divide the inner space of the cabinet body 10 into the cold air duct 201 on the left and the hot air duct 202 on the right. Cold air enters a cooling channel and is guided to the air intake vent on the left of the device 30 by the air deflection parts 22. The cold air dissipates heat from the device 30; then enters the hot air duct 202 through the air exhaust vent on the right of the device 30; and is finally discharged to the outside.

In this embodiment, that the cold air duct 201 and the hot air duct 202 are isolated from each other is specifically: cold air in the cold air duct 201 and hot air in the hot air duct 202 are separated from each other.

In this embodiment, a quantity of air deflection parts 22 is specifically set based on the quantity of devices 30 disposed in the cabinet body 10. For example, when there are three devices 30, there are four air deflection parts 22. In this way, the four air deflection parts 22 form three intervals into which the three devices 30 can be inserted. In this embodiment, adjacent air deflection parts 22 may be equally spaced or unequally spaced.

In this embodiment, one end of the air deflection part 22 may be connected to the air baffle 21 or an inner wall of the cabinet body 10, and the other end of the air deflection part 22 may press against an inner wall of the cabinet body 10, or the other end of the air deflection part 22 is removably connected to an inner wall of the cabinet body 10. In this embodiment, to fully dissipate heat for the device 30, the part that is of the device 30 and that is located in the cold air duct 201 is larger than the part that is of the device 30 and that is located in the hot air duct 202. Therefore, the other end of the air deflection part 22 inclines toward the end that is of the device 30 and on which the air exhaust vent is provided, so that a contact area of the device 30 with cold air is relatively large, thereby ensuring good heat dissipation for the device 30.

In this embodiment, the air baffle 21 is specifically securely connected to the inner wall of the cabinet body 10 by using a screw or in a snap-fitting manner. In addition, in this embodiment, the air baffle 21 may be installed vertically in the cabinet body 10, as shown in FIG. 2B. In this way, the plurality of air deflection parts 22 are alternately disposed in sequence along a longitudinal edge of the air baffle 21, and each device 30 is laterally inserted into each interval. The inner space of the cabinet body 10 is divided into a left air duct and a right air duct, namely the cold air duct 201 and the hot air duct 202. In this embodiment, it should be noted that, when the devices 30 are arranged laterally in the cabinet body 10, two air duct systems 20 can be disposed in the cabinet body 10. As shown in FIG. 2A, two air duct systems 20 are disposed in the cabinet body 10, with one on the top and one at the bottom. In this embodiment, alternatively, more than two air duct systems 20 may be disposed based on the quantity of devices 30 disposed in the cabinet body 10. In this way, devices 30 of a shallow depth can be inserted into one air duct system 20, and deep devices 30 can be inserted into another air duct system 20, so that devices 30 of different depths can be disposed concurrently in the cabinet. In comparison with a conventional-technology cabinet, the air duct system 20 in the cabinet provided in this embodiment is a flexible air duct system, and therefore can accommodate devices 30 of different depths, so that devices 30 of different depths can be integrated in the cabinet and centrally deployed, greatly improving a degree of integration and competitiveness of the cabinet.

Alternatively, in this embodiment, the air baffle 21 may be disposed horizontally in the cabinet body 10. In other words, the air baffle 21 is disposed laterally. In this case, the plurality of air deflection parts 22 are disposed laterally at an interval along a lateral edge of the air baffle 21, the device 30 is arranged vertically in the cabinet, and the inner space of the cabinet body 10 is divided into an upper air duct and a lower air duct, namely the cold air duct 201 and the hot air duct 202.

In this embodiment, one or more air duct systems may be disposed in the cabinet. As shown in FIG. 2A, two air duct systems are disposed in the cabinet body 10. In this case, a device 30b of a large depth may be installed in one of the air duct systems, and a device 30a of a small depth is installed in the other air duct system. When the device 30b is installed, an air baffle 21 in the one air duct system is compressed. When the device 30a is installed, an air baffle 21 in the other air duct system is not compressed. In addition, a device with a left air intake vent may be installed in one of the two air duct systems, and a device with a right air intake vent may be installed in the other air duct system. Therefore, in this embodiment, at least two air duct systems are disposed in the cabinet, so that devices of different depths and devices having different air intake modes can be installed concurrently in the cabinet, thereby enabling the cabinet to accommodate devices of different depths and devices having different air intake modes.

Therefore, in the cabinet provided in this application, the air duct system 20 includes the plurality of air deflection parts 22 and the air baffle 21 that is scalable along the insertion direction of the device 30, where the plurality of air deflection parts 22 are alternately disposed along the air baffle 21; the air baffle 21 is connected to an inner wall of the cabinet body 10; and when the device 30 is inserted into a spacing, the plurality of air deflection parts 22 and the air baffle 21 divide the inner space of the cabinet body 10 into the cold air duct 201 and the hot air duct 202 that are isolated from each other, thereby forming a flexible air duct. When devices 30 of different depths are inserted into a spacings, the air baffle 21 in the air duct system 20 can be scaled, so that the flexible air duct can accommodate devices 30 of different depths. In this way, the cabinet is not limited to accommodating only devices 30 of one depth, but can accommodate of devices 30 of different depths. Moreover, the air deflection parts 22 are independent components, and positions of the air deflection parts 22 can be adjusted based on air intake modes of the devices, so that the cabinet can accommodate devices having different air intake modes, thereby expanding an applicable scope of the cabinet and greatly improving a degree of integration and competitiveness of the cabinet. In addition, the air duct system 20 is a flexible air duct. In this way, positions of the air baffle 21 and the air deflection parts 22 do not need to be changed during replacement of devices 30 in the cabinet, facilitating replacement and reducing the difficulty in replacing devices 30 onsite. Therefore, the cabinet provided in this embodiment can accommodate devices 30 of different depths and devices having different air intake modes. This reduces the difficulty in replacing devices 30 onsite and resolves the problem that a conventional-technology cabinet cannot accommodate devices 30 of different depths and devices having different air intake modes.

On a basis of the foregoing descriptions of this embodiment, in this embodiment, specifically, the air intake vent of the device 30 is located in the cold air duct. The air intake vent provided on the cabinet body 10 is connected to the cold air duct. In other words, an inner wall that is of the cabinet body 10 and on which the air intake vent is provided is located in the cold air duct. The air exhaust vent of the device 30 and an inner wall that is of the cabinet body 10 and on which the air exhaust vent is provided are both located in the hot air duct. In addition, one side of the plurality of air deflection parts 22, one side of the air baffle 21, and some inner walls of the cabinet body 10 enclose to form the cold air duct 201; and the other side of the plurality of air deflection parts 22, the other side of the air baffle 21, and remaining inner walls of the cabinet body 10 enclose to form the hot air duct 202. In other words, in this embodiment, after the device 30 is inserted into a spacing between the air deflection parts 22, the cold air duct 201 is enclosed by the one side of the plurality of air deflection parts 22, the one side of the air baffle 21, and some inner walls of the cabinet body 10; and the hot air duct 202 is enclosed by the other side of the plurality of air deflection parts 22, the other side of the air baffle 21, and the remaining inner walls of the cabinet body 10.

On a basis of the foregoing descriptions of this embodiment, in this embodiment, specifically, one end of the air deflection part 22 is connected to the air baffle 21, and the other end of the air deflection part 22 is connected to an inner wall of the cabinet body 10. When the one end of the air deflection part 22 is connected to the air baffle 21, and the other end of the air deflection part 22 is connected to the inner wall of the cabinet body 10, a length of the air deflection part 22 needs to be adjustable in a scaling process of the air baffle 21. Therefore, in this embodiment, the air deflection part 22 is an air deflection part with an adjustable length. Specifically, as shown in FIG. 2C, when a device 30a of a shallow depth is disposed in the cabinet body 10, a length of the air deflection part 22 is L1. When a device 30b of a large depth is disposed in the cabinet body 10, the air deflection part 22 is elongated to a length of L2, where L2 > L1. In other words, the air deflection part 22 is elongated when the air baffle 21 is compressed.

To make the length of the air deflection part 22 adjustable, specifically, in this embodiment, the air deflection part 22 is made of an elastic material, so that the air deflection part 22 is elastic. When the length of the air deflection part 22 needs to be extended, the air deflection part 22 can be elongated. When the air deflection part 22 needs to be shortened, the air deflection part 22 draws back, so that the length of the air deflection part 22 is adjustable. During a scaling process of the air baffle 21, the length of the air deflection part 22 is adjustable owing to the elasticity of the air deflection part 22.

Alternatively, in this embodiment, to make the length of the air deflection part 22 adjustable, specifically, the air deflection part 22 includes at least two air deflection panels (not illustrated) that are slidably connected to each other. In this way, for a device 30 of a shallow depth, the at least two air deflection panels overlap with each other. When a deep device 30 is inserted, two air deflection panels may slide apart, to extend the length of the air deflection part 22, thereby making the length of the air deflection part 22 adjustable. In this embodiment, an implementation of the at least two air deflection panels that are slidably connected to each other is similar to that of a drawer or a foldable umbrella. It should be noted that in this embodiment, implementations for making the length of the air deflection part 22 adjustable include but are not limited to the foregoing two manners. The length of the air deflection part 22 can be made adjustable by using other arrangement manners. For example, alternatively, two ends of the air deflection part 22 may be made of an elastic material while other parts of the air deflection part 22 are made of a metallic or nonmetallic material.

In this embodiment, specifically, the air deflection part 22 includes a first air deflection panel and a second air deflection panel, one end of the first air deflection panel is rotatably connected to the air baffle 21, the other end of the first air deflection panel is slidably connected to one end of the second air deflection panel, and the other end of the second air deflection panel is connected to the inner wall of the cabinet body 10. During installation of devices 30 of different depths, the devices 30 exert force on one end of the air baffle 21, so that the air baffle 21 is compressed and drives the first air deflection panel to move. The first air deflection panel continuously slides outward on the second air deflection panel, thereby extending the length of the air deflection part 22.

In this embodiment, when the length of the air deflection part 22 is adjustable, during replacement of devices of different depths, installation can be completed just by pushing the devices to move toward the air baffle 21. The entire installation process is convenient and easy, and positions of the air baffle 21 and the air deflection parts 22 do not need to be changed, facilitating onsite replacement of devices.

In a conventional-technology cabinet, a position of an air duct enclosure is fixed. Therefore, an air duct system 20 can accommodate only a device 30 with a left air intake vent but cannot accommodate a device 30 with a right air intake vent. Therefore, in this embodiment, to accommodate devices 30 having different air intake modes, specifically, one end of the air deflection part 22 is rotatably connected to the air baffle 21, and the other end of the air deflection part 22 can rotate around the air baffle 21. In this way, as shown in FIG. 2C, when a device 30a is a device with a left air intake vent, the other end of the air deflection part 22 inclines to the right. In this way, as indicated by the dotted arrows in FIG. 2C, after cold air enters the cabinet body 10, the cold air is guided to the left air intake vent of the device 30a by the air deflection part 22. When a device 30c is a device with a right air intake vent (as shown in FIG. 2E), the other end of the air deflection part 22 rotates to the left side and assumes an inclined state. In this way, after cold air enters the cabinet body 10, the cold air is guided to the right air intake vent of the device 30 by the air deflection part 22. Therefore, in this embodiment, the formed flexible air duct is not only applicable to a device 30 with a left air intake vent, but also applicable to a device 30 with a right air intake vent, thereby accommodating devices 30 having different air intake modes and resolving the problem that the conventional-technology cabinet cannot accommodate devices having different air intake modes. In this way, during centralized deployment of baseband processing units in a cloud radio access network (cloud radio access network, CRAN for short), even if mainstream devices 30 vary relatively greatly in air intake modes and depths, centralized deployment of different devices 30 can still be implemented, because the air duct system 20 in the cabinet provided in this embodiment can accommodate devices 30 of different depths and having different air intake modes.

In this embodiment, the air deflection part 22 and the air baffle 21 are specifically rotatably connected to each other by using a rotating shaft, a hinge, or a flexible material. For example, a rotating shaft may be disposed on the air baffle 21, and each air deflection part 22 is rotatably connected to the rotating shaft, ultimately making the air deflection part 22 rotatable. In this embodiment, when the air deflection part 22 is rotatably connected by using a flexible material, the flexible material may be specifically flameproof fabric or rubber.

In this embodiment, it should be noted that when the air deflection part 22 is made of an elastic material, one end of the air deflection part 22 and the air baffle 21 may be connected rotatably or connected non-rotatably with each other. The one end that is of the air deflection part 22 and that is connected to the air baffle 21 is rotatable owing to a deformable characteristic of the elastic material. When a device having a different air intake mode needs to be accommodated, the air deflection part 22 can be installed by just pulling the one end of the air deflection part 22 to another position.

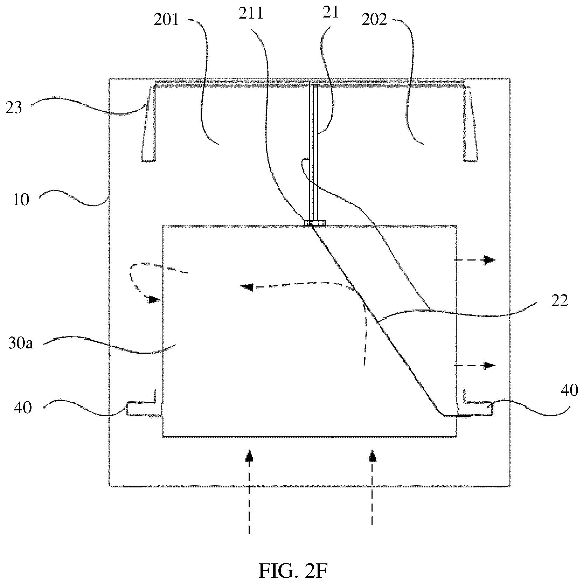

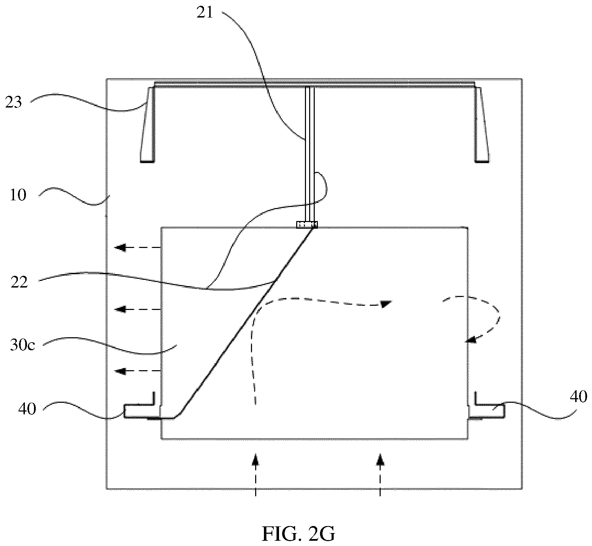

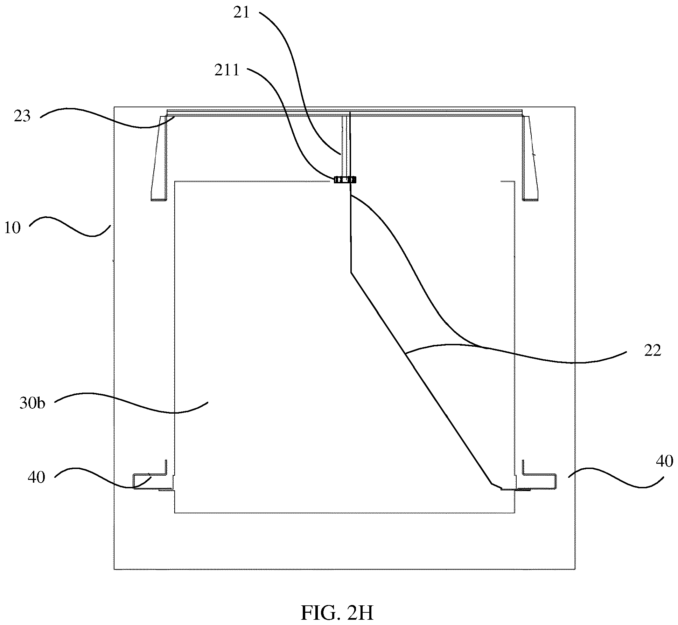

FIG. 2F is another top-view schematic structural diagram of an air duct system and a device with a left air intake vent in the cabinet according to Embodiment 1 of this application. FIG. 2G is another top-view schematic structural diagram of an air duct system and a device with a right air intake vent in the cabinet according to Embodiment 1 of this application. FIG. 2H is still another top-view schematic structural diagram of an air duct system and another device with a left air intake vent in the cabinet according to Embodiment 1 of this application. As shown in FIG. 2F to FIG. 2H, in this embodiment, a length of the air deflection part 22 may be fixed. In other words, the length of the air deflection part 22 remains unchanged in a scaling process of the air baffle 21. In this embodiment, the air deflection part 22 and the air baffle 21 are not connected to each other. Specifically, a guide rail 211 is provided on one end of the air baffle 21 that faces the device 30. Both sides of the guide rail 211 are provided with a sliding slot for the air deflection part 22 to pass through, one end of the air deflection part 22 is connected to an inner wall of the cabinet body 10, the other end of the air deflection part 22 passes through the sliding slot and extends to the end of the air baffle 21 that is connected to the cabinet body 10, and the guide rail 211 slides on the air deflection part 22 when the air baffle 21 is compressed. However, the length of the air deflection part 22 remains unchanged. Specifically, as shown in FIG. 2H, a device 30b is a device with a relatively large depth. In this case, the guide rail 211 moves when the air baffle 21 is compressed, and the length of the air deflection part 22 remains unchanged. In addition, in this embodiment, as shown in FIG. 2G, when a device 30c is provided with a right air intake vent, in other words, when the device has a different air intake mode, one end of the air deflection part 22 is removed from a sliding slot on one side of the guide rail 211 and installed to a sliding slot on the other side, so that the air deflection part 22 can accommodate the device 30 having another air intake mode. In this embodiment, the air deflection part 22 collaborates with different sliding slots on the guide rail 211, enabling the air duct system 20 to accommodate devices 30 having different air intake modes, so that the cabinet can accommodate devices 30 having different air intake modes.

In this embodiment, to make the air baffle 21 scalable, specifically, a material of the air baffle 21 is sponge, a flexible material, an elastic material, or a structure formed by a combination of an elastic material and a metallic or nonmetallic material. To be specific, in this embodiment, the air baffle 21 may be an air baffle 21 made of sponge. In this way, when a deep device 30 is inserted, the sponge is compressed. When a device 30 of a shallow depth is installed, the sponge is in an outspread state. Alternatively, in this embodiment, the air baffle 21 is a structure formed by a combination of an elastic material and a metallic material, or the air baffle 21 is a structure formed by a combination of an elastic material and a nonmetallic material. Alternatively, in this embodiment, a flexible material can be deformed under action of external force. Therefore, the air baffle 21 may be a deformable flexible board. It should be noted that in this embodiment, the material of the air baffle 21 includes but is not limited to sponge, a flexible material, an elastic material, or a structure formed by a combination of an elastic material and a metallic or nonmetallic material, and may alternatively be another scalable material.

In this embodiment, one end of the air deflection part 22 needs to be connected to an inner wall of the cabinet body 10. However, when the other end of the air deflection part 22 is connected to the air baffle 21, this end of the air deflection part 22 moves when the air baffle 21 is compressed. In this case, the end that is of the air deflection part 22 and that is connected to the cabinet body 10 needs to divert to some extent. Therefore, to make the end that is of the air deflection part 22 and that is connected to the cabinet body 10 easy to divert in an elongation process of the air deflection part 22, as shown in FIG. 2B, a rotatable fastening portion 221 is provided on the other end of the air deflection part 22 that is away from the air baffle 21. The fastening portion 221 is configured to connect the other end of the air deflection part 22 to the cabinet body 10, and the fastening portion 221 is rotatable relative to the air deflection part 22. In this way, the end that is of the air deflection part 22 and that is connected to the cabinet body 10 is easy to divert in the elongation process of the air deflection part 22. The fastening portion 221 may be specifically formed by bending one end of the air baffling part 21, and a bending position has undergone reduction processing, so that the fastening portion 221 can rotate. Alternatively, the fastening portion 221 and the air deflection part 22 are connected to each other by using a hinge or a flexible material. In this embodiment, the fastening portion 221 may be removably connected to the inner wall of the cabinet body 10 by using a screw.

In this embodiment, as shown in FIG. 2A, at least two mounting bars 40 are further provided in the cabinet body 10. The fastening portion 221 is connected to the cabinet body 10 by using the mounting bars 40. In this way, after the device 30 is inserted into a spacing between the air deflection parts 22, each air deflection part 22 is connected to the inner wall of the cabinet body 10 by connecting the fastening portion 221 to one of the mounting bars 40. When the air deflection part 22 needs to guide air for a device having a different air intake mode, the fastening portion 221 of the air deflection part 22 is connected to the other mounting bars 40. In this embodiment, as shown in FIG. 2A, two mounting bars 40 are provided in the cabinet body 10, and the two mounting bars 40 are respectively located on two sides of the air baffle 21 and are connected to inner walls of the cabinet body 10.

In this embodiment, to facilitate connection between the air baffle and the inner wall of the cabinet body 10, specifically, the cabinet further includes a bracket 23. The air baffle 21 is connected to the inner wall of the cabinet body 10 by using the bracket 23. In addition, the bracket 23 and the air deflection parts 22 are respectively located on two opposite edges of the air baffle 21. Specifically, as shown in FIG. 2B, the plurality of air deflection parts 22 are alternately disposed along one longitudinal edge of the air baffle 21, and the bracket 23 is connected to the other longitudinal edge of the air baffle 21. In addition, in this embodiment, the mounting bar 40 may also be connected to the bracket 40, and a cross rod is disposed between the mounting bar 40 and the bracket 40, for installing a device between two air deflection parts 22.

In this embodiment, the bracket 23 includes a plurality of U-shaped enclosures 23a. The plurality of U-shaped enclosures 23a are connected to the air deflection panel in a spaced manner. As shown in FIG. 2B, the bracket 23 includes three U-shaped enclosures 23a. The three U-shaped enclosures 23a are respectively connected to a top end, a middle section, and a bottom end of the air baffle 21. It should be noted that in this embodiment, a quantity of U-shaped enclosures 23a includes but is not limited to 3, and may alternatively be 4 or 2.

In this embodiment, when the air baffle 21 is connected to a U-shaped enclosure 23a, specifically, the air baffle 21 is connected to a middle edge of the U-shaped enclosure 23a, and a position at which the air baffle 21 is connected to the U-shaped enclosure 23a is in the middle of the U-shaped enclosure 23a.

Further, the cabinet further includes an elastic part. The elastic part is connected to the air baffle 21, and the elastic part is configured to drive the compressed air baffle 21 to stretch out. In this way, after the air baffle 21 is compressed, when the air baffle 21 cannot stretch out by using its own elastic force, the elastic part can drive the air baffle 21 to stretch out. Therefore, in this embodiment, the air baffle 21 can stretch out rapidly by using the elastic part and the elastic force of the air baffle 21. In this embodiment, the elastic part is specifically sleeved on a fixed shaft. One end of the elastic part is connected to the fixed shaft, and the other end of the elastic part can slide along the fixed shaft and is compressed when the air baffle 21 is compressed. In addition, the elastic part is connected to one end of the air baffle 21. When external force is withdrawn, the compressed elastic part drives the air baffle 21 to stretch out. In this embodiment, an elastic part can be disposed along both compressible ends of the air baffle 21, and the two elastic parts can respectively drive the two ends of the air baffle 21 to stretch out.

### Embodiment 2

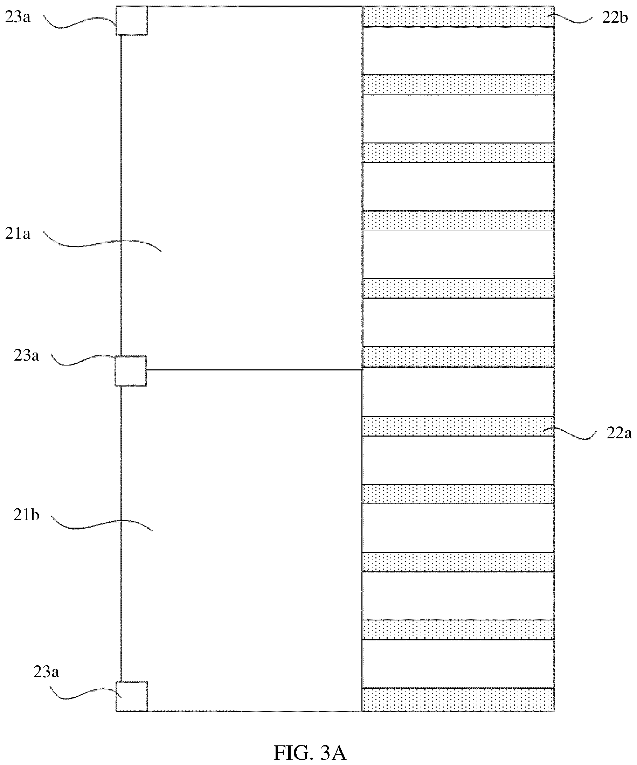

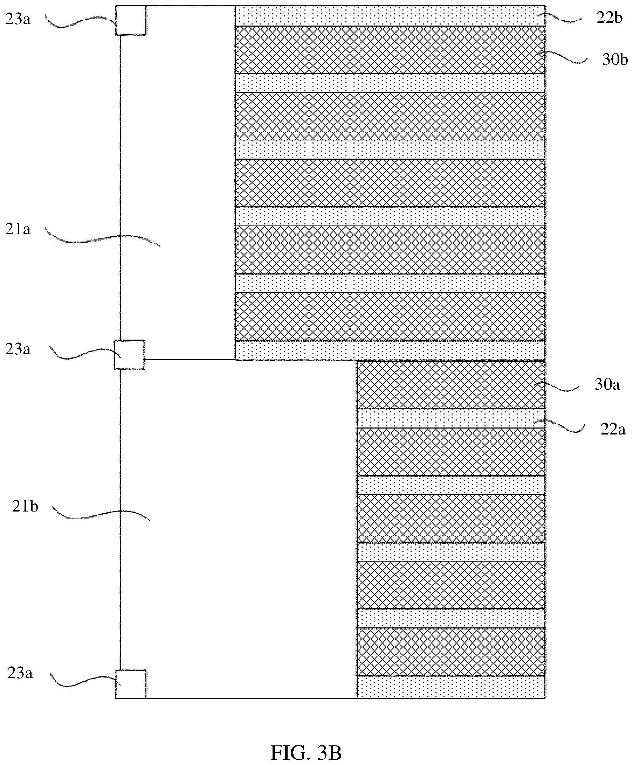

FIG. 3A is a side-view schematic structural diagram of an air duct system in a cabinet according to Embodiment 2 of this application. FIG. 3B is a side-view schematic structural diagram of an air duct system 20 into which devices of different depths are inserted in the cabinet according to Embodiment 2 of this application.

On a basis of the foregoing embodiment, in this embodiment, further, to implement concurrent installation of devices 30 of different depths in the cabinet, specifically, as shown in FIG. 3A and FIG. 3B, an air baffle 21 includes at least two sub air baffles. As shown in FIG. 3A, the air baffle 21 includes a sub air baffle 21a and a sub air baffle 21b. The at least two sub air baffles are disposed in sequence in a direction perpendicular to an insertion direction, and space between two adjacent sub air baffles is sealed. Specifically, in this embodiment, the air baffle 21 is divided into at least two sub air baffles that are independent of each other. The sub air baffles need to be disposed closely next to each other, so that the air baffle 21 formed by the at least two sub air baffles has no spacing. This can ensure that cold air in a cold air duct 201 and hot air in a hot air duct 202 are separated. In this embodiment, the at least two sub air baffles that are independent of each other are included. For example, as shown in FIG. 3A, the air baffle 21 may include the sub air baffle 21a and the sub air baffle 21b. An air deflection part 22b is disposed on the sub air baffle 21a, and an air deflection part 22a is disposed on the sub air baffle 21b. When no device is inserted, the air deflection part 22b and the air deflection part 22a are of the same length. When a device 30b of a large depth is inserted, the sub air baffle 21a that corresponds to the device 30b of a large depth is compressed, the air deflection part 22b connected to the sub air baffle 21a is elongated, and other sub air baffles are in an outspread state (that is, not compressed). A length of the air deflection part 22a that is connected to the sub air baffle 21b remains unchanged. When a device 30a of a shallow depth is inserted, the sub air baffle 21b is not compressed. In this embodiment, a quantity of sub air baffles disposed may be specifically set based on different depths of devices 30. For example, when devices 30 of three different depths need to be installed in the cabinet, three sub air baffles may be included. In this way, devices 30 of each depth correspond to one sub air baffle. The sub air baffles scale based on corresponding devices 30 of different depths. This enables the air duct system 20 in the cabinet to concurrently accommodate devices 30 of different depths. In this way, during centralized deployment of baseband processing units in a CRAN, the cabinet can implement centralized deployment of devices 30 of different depths.

In this embodiment, the at least two sub air baffles are included. In this way, devices of different depths can be accommodated concurrently even when one air duct system is disposed in the cabinet. In comparison with a solution of disposing two air duct systems in the cabinet to implement concurrent installation of devices of different depths, in this embodiment, devices of different depths can be accommodated concurrently by disposing only one air duct system.

### Embodiment 3

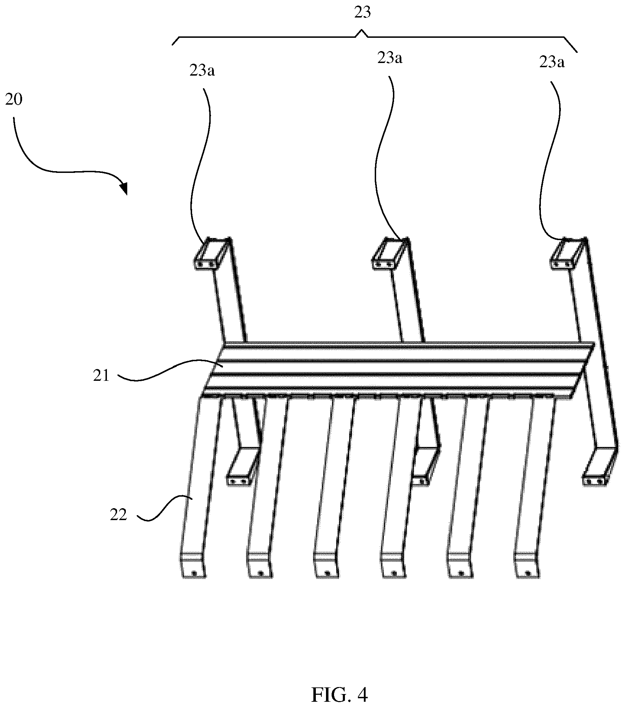

FIG. 4 is a schematic structural diagram of an air duct system in a cabinet according to Embodiment 3 of this application.

In this embodiment, when a device 30 in the cabinet is relatively long, if the device 30 is arranged laterally in the cabinet, a width of the cabinet needs to be relatively large, resulting in a relatively large floor area of the cabinet. Therefore, in this embodiment, specifically, as shown in FIG. 4, an air baffle 21 is disposed horizontally in a cabinet body 10. To be specific, when the air baffle 21 is disposed laterally, a plurality of air deflection parts 22 are disposed laterally at an interval along a long edge of the air baffle 21. In this way, during installation of the device 30, the device 30 can be arranged vertically in the cabinet. Inner space of the cabinet body 10 is divided into an upper air duct and a lower air duct, that is, a cold air duct 201 and a hot air duct 202. In this embodiment, the device 30 can be installed vertically in the cabinet body 10. This avoids the problem of a relatively large floor area of the cabinet caused by lateral arrangement of the device 30 that is relatively long.

In this embodiment, it should be noted that, when devices 30 are installed vertically in the cabinet, two air duct systems 20 can be disposed, so that two rows of vertical devices 30 can be installed in the cabinet. In the two air duct systems 20, a cold air duct 201 formed by a first air duct system 20 and a cold air duct 201 formed by a second air duct system 20 may be disposed face to face, and two formed hot air ducts 202 are respectively located at an upper section and a lower section in the cabinet body 10. In the two rows of devices 30 installed, devices 30 of a shallow depth may be selected as devices 30 in a first row, and deep devices 30 may be selected as devices 30 in a second row. In this way, the two air duct systems 20 are used to implement concurrent arrangement of devices 30 of different depths in the cabinet, thereby implementing centralized deployment of different devices 30.

### Embodiment 4

This embodiment provides a flexible air duct system. Specifically, as shown in FIG. 2B, the flexible air duct system includes a plurality of air deflection parts 22 and an air baffle 21 that is scalable along an insertion direction of a device 30 in a cabinet. To be specific, in this embodiment, to accommodate devices 30 of different depths, the air baffle 21 is scalable, and the air baffle 21 is specifically scalable along the insertion direction of the device 30. For example, as shown in FIG. 2C, when a device 30 in the cabinet is inserted from front to back, the air baffle 21 is scalable in a front-back direction. In this way, when a device 30b in the cabinet is of a relatively large depth, as shown in FIG. 2D, the air baffle 21 is compressed in the front-back direction. Therefore, in this embodiment, an air duct formed in the cabinet is a flexible air duct. When the devices 30 installed in the cabinet are of different depths, the air baffle 21 in the air duct system 20 can be scaled, so that the air duct system 20 can accommodate the installation of the devices 30 of different depths. In this way, the devices 30 installed in the cabinet are not limited to devices 30 of one depth, and devices 30 of other depths can also be installed. In other words, the cabinet provided in this embodiment can accommodate devices 30 of different depths, including both devices 30 of large depths and devices 30 of shallow depths. In addition, positions of the air deflection parts 22 can be adjusted based on devices having different air intake modes, so that the cabinet can accommodate devices having different air intake modes, thereby expanding an applicable scope of the cabinet and greatly improving a degree of integration and competitiveness of the cabinet. Moreover, the air baffle 21 in the air duct system 20 is scalable. In this way, positions of the air baffle 21 and the air deflection parts 22 do not need to be changed during replacement of devices 30 of different depths in the cabinet, facilitating replacement and reducing the difficulty in replacing devices 30 onsite.

In this embodiment, one end of the air baffle 21 is connected to an inner wall of a cabinet body 10, and the other end of the air baffle 21 presses against the device 30. The plurality of air deflection parts 22 are alternately disposed along the air baffle 21 in the cabinet body 10. An interval H exists between two adjacent air deflection parts 22. The device 30 is inserted into a spacing H during installation. However, it should be noted that when the device 30 is inserted into a spacing between the air deflection parts 22, space between the air deflection parts 22 and the device 30 needs to be sealed, to ensure that air ducts on two sides of an air deflection part 22 are isolated and separated from each other. In this embodiment, as shown in FIG. 2B, the air baffle 21 includes two long edges that are opposite to each other and two short edges that are opposite to each other. One of the long edges of the air baffle 21 is connected to the inner wall of the cabinet body 10, and the plurality of air deflection parts 22 are alternately disposed along the other long edge of the air baffle 21.

In addition, in this embodiment, when the device 30 is inserted into a spacing H between the air deflection parts 22, the plurality of air deflection parts 22 and the air baffle 21 divide inner space of the cabinet body 10 into a cold air duct 201 and a hot air duct 202 that are isolated from each other. After the device 30 is installed, a part of the device 30 is located in the cold air duct 201, and the other part of the device 30 is located in the hot air duct 202. An end that is of the device 30 and on which an air intake vent is provided needs to be located in the cold air duct 201, and an end that is of the device 30 and on which an air exhaust vent is provided needs to be located in the hot air duct 202. After cold air enters the cold air duct 201, the cold air is guided to the air intake vent of the device 30 by the air deflection parts 22, and is discharged into the hot air duct 202 through the air exhaust vent of the device 30 after passing through the device 30. The hot air duct 202 is connected to an air exhaust vent on the cabinet body 10. Finally, hot air is discharged to the outside through the air exhaust vent on the cabinet body 10. Specifically, as shown in FIG. 2C, an air intake mode of the device 30 is left-in, right-out. In this case, the air deflection parts 22 and the air baffle 21 divide the inner space of the cabinet body 10 into the cold air duct 201 on the left and the hot air duct 202 on the right. Cold air enters a cooling channel and is guided to the air intake vent on the left of the device 30 by the air deflection parts 22. The cold air dissipates heat from the device 30; then enters the hot air duct 202 through the air exhaust vent on the right of the device 30; and is finally discharged to the outside.

In this embodiment, that the cold air duct 201 and the hot air duct 202 are isolated from each other is specifically: cold air in the cold air duct 201 and hot air in the hot air duct 202 are separated from each other.

In this embodiment, a quantity of air deflection parts 22 is specifically set based on a quantity of devices 30 disposed in the cabinet body 10. For example, when there are three devices 30, there are four air deflection parts 22. In this way, the four air deflection parts 22 form three intervals into which the three devices 30 can be inserted. In this embodiment, adjacent air deflection parts 22 may be equally spaced or unequally spaced.

In this embodiment, one end of the air deflection part 22 may be connected to the air baffle 21 or an inner wall of the cabinet body 10, and the other end of the air deflection part 22 may press against an inner wall of the cabinet body 10, or the other end of the air deflection part 22 is removably connected to an inner wall of the cabinet body 10. In this embodiment, to fully dissipate heat for the device 30, the part that is of the device 30 and that is located in the cold air duct 201 is larger than the part that is of the device 30 and that is located in the hot air duct 202. Therefore, the other end of the air deflection part 22 inclines toward the end that is of the device 30 and on which the air exhaust vent is provided, so that a contact area of the device 30 with cold air is relatively large, thereby ensuring good heat dissipation for the device 30.

In this embodiment, the air baffle 21 is specifically securely connected to the inner wall of the cabinet body 10 by using a screw or in a snap-fitting manner. In addition, in this embodiment, the air baffle 21 may be installed vertically in the cabinet body 10, as shown in FIG. 2B. In this way, the plurality of air deflection parts 22 are alternately disposed in sequence along a longitudinal edge of the air baffle 21, and each device 30 is laterally inserted into each interval. The inner space of the cabinet body 10 is divided into a left air duct and a right air duct, namely the cold air duct 201 and the hot air duct 202. In this embodiment, it should be noted that, when the devices 30 are arranged laterally in the cabinet body 10, two air duct systems 20 can be disposed in the cabinet body 10. As shown in FIG. 2A, two air duct systems 20 are disposed in the cabinet body 10, with one on the top and one at the bottom. In this embodiment, alternatively, more than two air duct systems 20 may be disposed based on the quantity of devices 30 disposed in the cabinet body 10. In this way, devices 30 of a shallow depth can be inserted into one air duct system 20, and deep devices 30 can be inserted into another air duct system 20, so that devices 30 of different depths can be disposed concurrently in the cabinet. In comparison with a conventional-technology cabinet, the air duct system 20 in the cabinet provided in this embodiment is a flexible air duct system, and therefore can accommodate devices 30 of different depths, so that devices 30 of different depths can be integrated in the cabinet and centrally deployed, greatly improving a degree of integration and competitiveness of the cabinet.

Alternatively, in this embodiment, the air baffle 21 may be disposed horizontally in the cabinet body 10. In other words, the air baffle 21 is disposed laterally. In this case, the plurality of air deflection parts 22 are disposed laterally at an interval along a lateral edge of the air baffle 21, the device 30 is arranged vertically in the cabinet, and the inner space of the cabinet body 10 is divided into an upper air duct and a lower air duct, namely the cold air duct 201 and the hot air duct 202.

In this embodiment, one or more air duct systems may be disposed in the cabinet. As shown in FIG. 2A, two air duct systems are disposed in the cabinet body 10. In this case, a device 30b of a large depth may be installed in one of the air duct systems, and a device 30a of a small depth is installed in the other air duct system. When the device 30b is installed, an air baffle 21 in the one air duct system is compressed. When the device 30a is installed, an air baffle 21 in the other air duct system is not compressed. In addition, a device with a left air intake vent may be installed in one of the two air duct systems, and a device with a right air intake vent may be installed in the other air duct system. Therefore, in this embodiment, at least two air duct systems are disposed in the cabinet, so that devices of different depths and devices having different air intake modes can be installed concurrently in the cabinet, thereby enabling the cabinet to accommodate devices of different depths and devices having different air intake modes.

Therefore, in the flexible air duct system provided in this application, the air duct system 20 includes the plurality of air deflection parts 22 and the air baffle 21 that is scalable along the insertion direction of the device 30, where the plurality of air deflection parts 22 are alternately disposed along the air baffle 21; the air baffle 21 is connected to an inner wall of the cabinet body 10; and when the device 30 is inserted into a spacing, the plurality of air deflection parts 22 and the air baffle 21 divide the inner space of the cabinet body 10 into the cold air duct 201 and the hot air duct 202 that are isolated from each other, thereby forming a flexible air duct. When devices 30 of different depths are inserted into a spacings, the air baffle 21 in the air duct system 20 can be scaled, so that the flexible air duct can accommodate devices 30 of different depths. In this way, the cabinet is not limited to accommodating only devices 30 of one depth, but instead, can accommodate of devices 30 of different depths. Moreover, the air deflection parts 22 are independent components, and positions of the air deflection parts 22 can be adjusted based on air intake modes of the devices, so that the flexible air duct system can accommodate devices having different air intake modes. When the flexible air duct system is applied to the cabinet, an applicable scope of the cabinet can be expanded, and a degree of integration and competitiveness of the cabinet can be greatly improved. In addition, the air duct system 20 is a flexible air duct. In this way, positions of the air baffle 21 and the air deflection parts 22 do not need to be changed during replacement of devices 30 in the cabinet, facilitating replacement and reducing the difficulty in replacing devices 30 onsite. Therefore, the flexible air duct system provided in this embodiment can accommodate devices 30 of different depths and devices having different air intake modes. This reduces the difficulty in replacing devices 30 onsite and resolves the problem that a conventional-technology cabinet cannot accommodate devices 30 of different depths.

On a basis of the foregoing embodiments, in this embodiment, specifically, the air intake vent of the device 30 is located in the cold air duct. An air intake vent provided on the cabinet body 10 is connected to the cold air duct. In other words, an inner wall that is of the cabinet body 10 and on which the air intake vent is provided is located in the cold air duct. The air exhaust vent of the device 30 and an inner wall that is of the cabinet body 10 and on which the air exhaust vent is provided are both located in the hot air duct. In addition, one side of the plurality of air deflection parts 22, one side of the air baffle 21, and some inner walls of the cabinet body 10 enclose to form the cold air duct 201; and the other side of the plurality of air deflection parts 22, the other side of the air baffle 21, and remaining inner walls of the cabinet body 10 enclose to form the hot air duct 202. In other words, in this embodiment, after the device 30 is inserted into a spacing between the air deflection parts 22, the cold air duct 201 is enclosed by the one side of the plurality of air deflection parts 22, the one side of the air baffle 21, and some inner walls of the cabinet body 10; and the hot air duct 202 is enclosed by the other side of the plurality of air deflection parts 22, the other side of the air baffle 21, and the remaining inner walls of the cabinet body 10.

In this embodiment, one end of the air deflection part 22 is connected to the air baffle 21, and the other end of the air deflection part 22 is connected to an inner wall of the cabinet body 10. When the one end of the air deflection part 22 is connected to the air baffle 21, and the other end of the air deflection part 22 is connected to the inner wall of the cabinet body 10, a length of the air deflection part 22 needs to be adjustable in a scaling process of the air baffle 21. Therefore, in this embodiment, the air deflection part 22 is an air deflection part with an adjustable length. Specifically, as shown in FIG. 2C, when a device 30a of a shallow depth is disposed in the cabinet body 10, a length of the air deflection part 22 is L1. When a device 30b of a large depth is disposed in the cabinet body 10, the air deflection part 22 is elongated to a length of L2, where L2 > L1. In other words, the air deflection part 22 is elongated when the air baffle 21 is compressed.

To make the length of the air deflection part 22 adjustable, specifically, in this embodiment, the air deflection part 22 is made of an elastic material, so that the air deflection part 22 is elastic. When the length of the air deflection part 22 needs to be extended, the air deflection part 22 can be elongated. When the air deflection part 22 needs to be shortened, the air deflection part 22 draws back, so that the length of the air deflection part 22 is adjustable. During a scaling process of the air baffle 21, the length of the air deflection part 22 is adjustable owing to the elasticity of the air deflection part 22.

Alternatively, in this embodiment, to make the length of the air deflection part 22 adjustable, specifically, the air deflection part 22 includes at least two air deflection panels (not illustrated) that are slidably connected to each other. In this way, for a device 30 of a shallow depth, the at least two air deflection panels overlap with each other. When a deep device 30 is inserted, two air deflection panels may slide apart, to extend the length of the air deflection part 22, thereby making the length of the air deflection part 22 adjustable. In this embodiment, an implementation of the at least two air deflection panels that are slidably connected to each other is similar to that of a drawer or a foldable umbrella. It should be noted that in this embodiment, implementations for making the length of the air deflection part 22 adjustable include but are not limited to the foregoing two manners. The length of the air deflection part 22 can be made adjustable by using other arrangement manners. For example, alternatively, two ends of the air deflection part 22 may be made of an elastic material while other parts of the air deflection part 22 are made of a metallic or nonmetallic material.

In this embodiment, specifically, the air deflection part 22 includes a first air deflection panel and a second air deflection panel, one end of the first air deflection panel is rotatably connected to the air baffle 21, the other end of the first air deflection panel is slidably connected to one end of the second air deflection panel, and the other end of the second air deflection panel is connected to the inner wall of the cabinet body 10. During installation of devices 30 of different depths, the devices 30 exert force on one end of the air baffle 21, so that the air baffle 21 is compressed and drives the first air deflection panel to move. The first air deflection panel continuously slides outward on the second air deflection panel, thereby extending the length of the air deflection part 22.

In this embodiment, when the length of the air deflection part 22 is adjustable, during replacement of devices of different depths, installation can be completed just by pushing the devices to move toward the air baffle 21. The entire installation process is convenient and easy, and positions of the air baffle 21 and the air deflection parts 22 do not need to be changed, facilitating onsite replacement of devices.

In a conventional-technology cabinet, a position of an air duct enclosure is fixed. Therefore, an air duct system 20 can accommodate only a device 30 with a left air intake vent but cannot accommodate a device 30 with a right air intake vent. Therefore, in this embodiment, to accommodate devices 30 having different air intake modes, specifically, one end of the air deflection part 22 is rotatably connected to the air baffle 21, and the other end of the air deflection part 22 can rotate around the air baffle 21. In this way, as shown in FIG. 2C, when a device 30a is a device with a left air intake vent, the other end of the air deflection part 22 inclines to the right. In this way, as indicated by the dotted arrows in FIG. 2C, after cold air enters the cabinet body 10, the cold air is guided to the left air intake vent of the device 30a by the air deflection part 22. When a device 30c is a device with a right air intake vent (as shown in FIG. 2E), the other end of the air deflection part 22 rotates to the left side and assumes an inclined state. In this way, after cold air enters the cabinet body 10, the cold air is guided to the right air intake vent of the device 30 by the air deflection part 22. Therefore, in this embodiment, the formed flexible air duct is not only applicable to a device 30 with a left air intake vent, but also applicable to a device 30 with a right air intake vent, thereby accommodating devices 30 having different air intake modes. In this way, during centralized deployment of baseband processing units in a cloud radio access network (cloud radio access network, CRAN for short), even if mainstream devices 30 vary relatively greatly in air intake modes and depths, centralized deployment of different devices 30 can still be implemented, because the air duct system 20 in the cabinet provided in this embodiment can accommodate devices 30 of different depths and having different air intake modes.

In this embodiment, the air deflection part 22 and the air baffle 21 are specifically rotatably connected to each other by using a rotating shaft, a hinge, or a flexible material. For example, a rotating shaft may be disposed on the air baffle 21, and each air deflection part 22 is rotatably connected to the rotating shaft, ultimately making the air deflection part 22 rotatable. In this embodiment, when the air deflection part 22 is rotatably connected by using a flexible material, the flexible material may be specifically flameproof fabric or rubber.

In this embodiment, it should be noted that when the air deflection part 22 is made of an elastic material, one end of the air deflection part 22 and the air baffle 21 may be connected rotatably or non-rotatably with each other. The one end that is of the air deflection part 22 and that is connected to the air baffle 21 is rotatable owing to a deformable characteristic of the elastic material. When a device having a different air intake mode needs to be accommodated, the air deflection part 22 can be installed by just pulling the one end of the air deflection part 22 to another position.

As shown in FIG. 2F to FIG. 2H, in this embodiment, a length of the air deflection part 22 may be fixed. In other words, the length of the air deflection part 22 remains unchanged in a scaling process of the air baffle 21. In this embodiment, the air deflection part 22 and the air baffle 21 are not connected to each other. Specifically, a guide rail 211 is provided on one end of the air baffle 21 that faces the device 30. Both sides of the guide rail 211 are provided with a sliding slot for the air deflection part 22 to pass through, one end of the air deflection part 22 is connected to an inner wall of the cabinet body 10, the other end of the air deflection part 22 passes through the sliding slot and extends to the end of the air baffle 21 that is connected to the cabinet body 10, and the guide rail 211 slides on the air deflection part 22 when the air baffle 21 is compressed. However, the length of the air deflection part 22 remains unchanged. Specifically, as shown in FIG. 2H, a device 30b is a device with a relatively large depth. In this case, the guide rail 211 moves when the air baffle 21 is compressed, and the length of the air deflection part 22 remains unchanged. In addition, in this embodiment, as shown in FIG. 2G, when a device 30c is provided with a right air intake vent, in other words, when the device has a different air intake mode, one end of the air deflection part 22 is removed from a sliding slot on one side of the guide rail 211 and installed to a sliding slot on the other side, so that the air deflection part 22 can accommodate the device 30 having another air intake mode. In this embodiment, the air deflection part 22 collaborates with different sliding slots on the guide rail 211, enabling the air duct system 20 to accommodate devices 30 having different air intake modes, so that the cabinet can accommodate devices 30 having different air intake modes.

In this embodiment, to make the air baffle 21 scalable, specifically, a material of the air baffle 21 is sponge, a flexible material, an elastic material, or a structure formed by a combination of an elastic material and a metallic or nonmetallic material. To be specific, in this embodiment, the air baffle 21 may be an air baffle 21 made of sponge. In this way, when a deep device 30 is inserted, the sponge is compressed. When a device 30 of a shallow depth is installed, the sponge is in an outspread state. Alternatively, in this embodiment, the air baffle 21 is a structure formed by a combination of an elastic material and a metallic material, or the air baffle 21 is a structure formed by a combination of an elastic material and a nonmetallic material. Alternatively, in this embodiment, a flexible material can be deformed under action of external force. Therefore, the air baffle 21 is a deformable flexible board. It should be noted that in this embodiment, the material of the air baffle 21 includes but is not limited to sponge, a flexible material, an elastic material, or a structure formed by a combination of an elastic material and a metallic or nonmetallic material, and may alternatively be another scalable material.

In this embodiment, one end of the air deflection part 22 needs to be connected to an inner wall of the cabinet body 10. However, when the other end of the air deflection part 22 is connected to the air baffle 21, this end of the air deflection part 22 moves when the air baffle 21 is compressed. In this case, the end that is of the air deflection part 22 and that is connected to the cabinet body 10 needs to divert to some extent. Therefore, to make the end that is of the air deflection part 22 and that is connected to the cabinet body 10 easy to divert in an elongation process of the air deflection part 22, as shown in FIG. 2B, a rotatable fastening portion 221 is provided on the other end of the air deflection part 22 that is away from the air baffle 21. The fastening portion 221 is configured to connect the other end of the air deflection part 22 to the cabinet body 10, and the fastening portion 221 is rotatable relative to the air deflection part 22. In this way, the end that is of the air deflection part 22 and that is connected to the cabinet body 10 is easy to divert in the elongation process of the air deflection part 22. The fastening portion 221 may be specifically formed by bending one end of the air deflection part 22, and a bending position has undergone reduction processing, so that the fastening portion 221 can rotate. Alternatively, the fastening portion 221 and the air deflection part 22 are connected to each other by using a hinge or a flexible material. In this embodiment, the fastening portion 221 may be removably connected to the inner wall of the cabinet body 10 by using a screw.

In this embodiment, to facilitate connection between the air baffle and the inner wall of the cabinet body 10, specifically, the flexible air duct system further includes a bracket 23. The air baffle 21 is connected to the inner wall of the cabinet body 10 by using the bracket 23. In addition, the bracket 23 and the air deflection parts 22 are respectively located on two opposite edges of the air baffle 21. Specifically, as shown in FIG. 2B, the plurality of air deflection parts 22 are alternately disposed along one longitudinal edge of the air baffle 21, and the bracket 23 is connected to the other longitudinal edge of the air baffle 21. In addition, in this embodiment, a mounting bar 40 may also be connected to the bracket 40, and a cross rod is disposed between the mounting bar 40 and the bracket 40, for installing a device between two air deflection parts 22.

In this embodiment, the bracket 23 includes a plurality of U-shaped enclosures 23a. The plurality of U-shaped enclosures 23a are connected to the air deflection panel in a spaced manner. As shown in FIG. 2B, the bracket 23 includes three U-shaped enclosures 23a. The three U-shaped enclosures 23a are respectively connected to a top end, a middle section, and a bottom end of the air baffle 21. It should be noted that in this embodiment, a quantity of U-shaped enclosures 23a includes but is not limited to 3, and may alternatively be 4 or 2.

In this embodiment, when the air baffle 21 is connected to a U-shaped enclosure 23a, specifically, the air baffle 21 is connected to a middle edge of the U-shaped enclosure 23a, and a position at which the air baffle 21 is connected to the U-shaped enclosure 23a is in the middle of the U-shaped enclosure 23a.

Further, the flexible air duct system further includes an elastic part. The elastic part is connected to the air baffle 21, and the elastic part is configured to drive the compressed air baffle 21 to stretch out. In this way, after the air baffle 21 is compressed, when the air baffle 21 cannot stretch out by using its own elastic force, the elastic part can drive the air baffle 21 to stretch out. Therefore, in this embodiment, the air baffle 21 can stretch out rapidly by using the elastic part and the elastic force of the air baffle 21. In this embodiment, the elastic part is specifically sleeved on a fixed shaft. One end of the elastic part is connected to the fixed shaft, and the other end of the elastic part can slide along the fixed shaft and is compressed when the air baffle 21 is compressed. In addition, the elastic part is connected to one end of the air baffle 21. When external force is withdrawn, the compressed elastic part drives the air baffle 21 to stretch out. In this embodiment, an elastic part can be disposed along both compressible ends of the air baffle 21, and the two elastic parts can respectively drive the two ends of the air baffle 21 to stretch out.

### Embodiment 5

For a flexible air duct system provided in this embodiment, refer to FIG. 3A and FIG. 3B. In this embodiment, further, to enable the flexible air duct system to concurrently accommodate devices 30 of different depths, specifically, as shown in FIG. 3A and FIG. 3B, an air baffle 21 includes at least two sub air baffles. As shown in FIG. 3A, the air baffle 21 includes a sub air baffle 21a and a sub air baffle 21b. The at least two sub air baffles are disposed in sequence in a direction perpendicular to an insertion direction, and space between two adjacent sub air baffles is sealed. Specifically, in this embodiment, the air baffle 21 is divided into at least two sub air baffles that are independent of each other. The sub air baffles need to be disposed closely next to each other, so that the air baffle 21 formed by the at least two sub air baffles has no spacing. This can ensure that cold air in a cold air duct 201 and hot air in a hot air duct 202 are separated. In this embodiment, the at least two sub air baffles that are independent of each other are included. For example, the sub air baffle 21a and the sub air baffle 21b are included. An air deflection part 22b is disposed on the sub air baffle 21a, and an air deflection part 22a is disposed on the sub air baffle 21b. When no device is inserted, the air deflection part 22b and the air deflection part 22a are of the same length. When a device 30b of a large depth is inserted, the sub air baffle 21a that corresponds to the device 30b of a large depth is compressed, the air deflection part 22b connected to the sub air baffle 21a is elongated, and other sub air baffles are in an outspread state (that is, not compressed). A length of the air deflection part 22a that is connected to the sub air baffle 21b remains unchanged. When a device 30a of a shallow depth is inserted, the sub air baffle 21b is not compressed. In this embodiment, a quantity of sub air baffles disposed may be specifically set based on different depths of devices 30. For example, when devices 30 of three different depths need to be installed in the cabinet, three sub air baffles may be included. In this way, devices 30 of each depth correspond to one sub air baffle. The sub air baffles scale based on corresponding devices 30 of different depths. This enables the air duct system 20 in the cabinet to concurrently accommodate devices 30 of different depths. In this way, during centralized deployment of baseband processing units in a CRAN, the cabinet can implement centralized deployment of devices 30 of different depths.

In this embodiment, the at least two sub air baffles are included. In this way, devices of different depths can be accommodated concurrently even when one air duct system is disposed in the cabinet. In comparison with a solution of disposing two air duct systems in the cabinet to implement concurrent installation of devices of different depths, in this embodiment, devices of different depths can be accommodated concurrently by disposing only one air duct system.

### Embodiment 6

For a flexible air duct system provided in this embodiment, refer to FIG. 4. As shown in FIG. 4, in this embodiment, further, when a device 30 in a cabinet is relatively long, if the device 30 is arranged laterally in the cabinet, a width of the cabinet needs to be relatively large, resulting in a relatively large floor area of the cabinet. Therefore, in this embodiment, specifically, as shown in FIG. 4, an air baffle 21 is disposed horizontally in the cabinet. To be specific, when the air baffle 21 is disposed laterally, a plurality of air deflection parts 22 are disposed laterally at an interval H along a long edge of the air baffle 21. In this way, during installation of the device 30, the device 30 can be arranged vertically in the cabinet. Inner space of the cabinet is divided into an upper air duct and a lower air duct, that is, a cold air duct 201 and a hot air duct 202. In this embodiment, the device 30 can be installed vertically in the cabinet. This avoids the problem of a relatively large floor area of the cabinet caused by lateral arrangement of the device 30 that is relatively long.

In this embodiment, it should be noted that, when devices 30 are installed vertically in the cabinet, two air duct systems 20 can be disposed, so that two rows of vertical devices 30 can be installed in the cabinet. In the two air duct systems 20, a cold air duct 201 formed by a first air duct system 20 and a cold air duct 201 formed by a second air duct system 20 may be disposed face to face, and two formed hot air ducts 202 are respectively located at an upper section and a lower section in the cabinet. In the two rows of devices 30 installed, devices 30 of a shallow depth may be selected as devices 30 in a first row, and deep devices 30 may be selected as devices 30 in a second row. In this way, the two air duct systems 20 are used to implement concurrent arrangement of devices 30 of different depths in the cabinet, thereby implementing centralized deployment of different devices 30.

In the descriptions in this application, it should be noted that, unless otherwise specified or limited, terms such as "installation", "connected", and "connection" should be construed in a broad sense, for example, may be a fixed connection, may be an indirect connection by using an intermediate medium, or may be an internal connection between two elements or an interaction relationship between two elements. A person of ordinary skills in the art can understand specific meanings of the foregoing terms in this application based on a specific case.

An apparatus or element in this application or an implied apparatus or element needs to have a specific direction and be constructed and operated in a specific direction, and therefore cannot be construed as a limitation to this application. In the descriptions of this application, "a plurality of" means two or more, unless otherwise precisely and specifically specified.

In the specification, claims, and accompanying drawings of this application, the terms "first", "second", "third", "fourth", and so on (if existent) are intended to distinguish between similar objects but do not necessarily indicate a specific order or sequence. It should be understood that the data termed in such a way are interchangeable in proper circumstances so that the embodiments of this application described herein can be implemented in orders except the order illustrated or described herein. Moreover, the terms "include", "contain" and any other variants mean to cover the non-exclusive inclusion, for example, a process, method, system, product, or device that includes a list of steps or units is not necessarily limited to those units, but may include other units not expressly listed or inherent to such a process, method, system, product, or device.

## Claims

1. A cabinet, comprising a cabinet body (10) and at least one device (30) disposed in the cabinet body (10), wherein
the cabinet body (10) is further provided with at least one air duct system (20), and the air duct system (20) comprises:
a plurality of air deflection parts (22) and an air baffle (21) that is scalable along an insertion direction of the device (30), wherein one end of the air baffle (21) is connected to an inner wall of the cabinet body (10), and the other end of the air baffle (21) presses against the device (30); the plurality of air deflection parts (22) are disposed along the air baffle (21) in the cabinet body (10), wherein an interval exists between two adjacent air deflection parts (22); and when the device (30) is inserted into a spacing, the plurality of air deflection parts (22) and the air baffle (21) divide inner space of the cabinet body (10) into a cold air duct (201) and a hot air duct (202) that are isolated from each other, wherein the interval and the spacing coincide;
wherein an air intake vent of the device (30) and an inner wall that is of the cabinet body (10) and on which an air intake vent is provided are both located in the cold air duct (201); an air exhaust vent of the device (30) and an inner wall that is of the cabinet body (10) and on which an air exhaust vent is provided are both located in the hot air duct (202); one side of the plurality of air deflection parts (22), one side of the air baffle (21), and some inner walls of the cabinet body (10) enclose to form the cold air duct (201); and the other side of the plurality of air deflection parts (22), the other side of the air baffle (21), and remaining inner walls of the cabinet body (10) enclose to form the hot air duct (202);
**characterized in that**
each air deflection part (22) is an air deflection part with an adjustable length; and one end of each air deflection part (22) is connected to the air baffle (21), and the other end of each air deflection part (22) is connected to an inner wall of the cabinet body (10); or
a guide rail (211) is disposed at one end of the air baffle (21) that faces the device (30), both sides of the guide rail (211) are provided with a sliding slot for the air deflection part (22) to pass through, one end of the air deflection part (22) is connected to an inner wall of the cabinet body (10), the other end of the air deflection part (22) passes through one of the sliding slots and extends to the end of the air baffle (21) that is connected to the cabinet body (10), and the guide rail (211) slides on the air deflection part (22) when the air baffle (21) is compressed.

2. The cabinet according to claim 1, wherein each air deflection part (22) is an air deflection part with an adjustable length and is made of an elastic material, so that the length of each air deflection part (22) is adjustable.

3. The cabinet according to claim 1, wherein each air deflection part (22) is an air deflection part with an adjustable length and consists of at least two air deflection panels that are slidably connected to each other, one end of each air deflection part (22) is rotatably connected to the air baffle (21), and the other end of each air deflection part (22) is connected to the inner wall of the cabinet body (10).

4. The cabinet according to claim 3, wherein each air deflection part (22) comprises a first air deflection panel and a second air deflection panel, one end of the first air deflection panel is rotatably connected to the air baffle (21), the other end of the first air deflection panel is slidably connected to one end of the second air deflection panel, and the other end of the second air deflection panel is connected to the inner wall of the cabinet body (10).

5. The cabinet according to claim 4, wherein each air deflection part (22) is rotatably connected to the air baffle (21) by using a rotating shaft, a hinge, or a flexible material.

6. The cabinet according to any one of claims 1 to 5, wherein the air baffle (21) comprises at least two sub air baffles (21a, 21b), and space between two adjacent sub air baffles (21a, 21b) is sealed.

7. The cabinet according to any one of claims 1 to 6, wherein a rotatable fastening portion (221) is provided at the end of each air deflection part (22) that is connected to the inner wall of the cabinet body (10), and the fastening portion (221) is configured to connect the end of each air deflection part (22) to the cabinet body (10).

8. The cabinet according to claim 7, wherein at least two mounting bars (40) are further provided in the cabinet body (10), and the mounting bars (40) are configured to connect the fastening portion (221) to the cabinet body (10).

9. The cabinet according to any one of claims 1 to 8, further comprising a bracket (23), wherein the air baffle (21) is connected to the inner wall of the cabinet body (10) by using the bracket (23).

## Patentansprüche

1. Schrank, umfassend einen Schrankkörper (10) und mindestens eine Vorrichtung (30), die in dem Schrankkörper (10) angeordnet ist, wobei
der Schrankkörper (10) ferner mit mindestens einem Luftkanalsystem (20) versehen ist und das Luftkanalsystem (20) umfasst:
eine Vielzahl von Luftumlenkungsteilen (22) und ein Luftleitblech (21), das entlang einer Einführrichtung der Vorrichtung (30) skalierbar ist, wobei ein Ende des Luftleitblechs (21) mit einer Innenwand des Schrankkörpers (10) verbunden ist und das andere Ende des Luftleitblechs (21) gegen die Vorrichtung (30) drückt; wobei die Vielzahl von Luftumlenkungsteilen (22) entlang des Luftleitblechs (21) in dem Schrankkörper (10) angeordnet sind, wobei ein Abstand zwischen zwei angrenzenden Luftumlenkungsteilen (22) besteht; und wenn die Vorrichtung (30) in einen Zwischenraum eingeführt wird, die Vielzahl von Luftumlenkungsteilen (22) und das Luftleitblech (21) einen Innenraum des Schrankkörpers (10) in einen Kaltluftkanal (201) und einen Warmluftkanal (202) teilen, die voneinander isoliert sind, wobei der Abstand und der Zwischenraum sich decken;
wobei eine Lufteinlassöffnung der Vorrichtung (30) und eine Innenwand, die zu dem Schrankkörper (10) gehört und an der eine Lufteinlassöffnung bereitgestellt ist, beide in dem Kaltluftkanal (201) gelegen sind; eine Luftauslassöffnung der Vorrichtung (30) und eine Innenwand, die zu dem Schrankkörper (10) gehört und an der eine Luftauslassöffnung bereitgestellt ist, beide in dem Heißluftkanal (202) gelegen sind; eine Seite der Vielzahl von Luftumlenkungsteilen (22), eine Seite des Luftleitblechs (21) und einige Innenwände des Schrankkörpers (10) sich anfügen, um den Kaltluftkanal (201) auszubilden; und die andere Seite der Vielzahl von Luftumlenkungsteilen (22), die andere Seite des Luftleitblechs (21) und die verbleibenden Innenwände des Schrankkörpers (10) sich anfügen, um den Heißluftkanal (202) auszubilden;
**dadurch gekennzeichnet, dass**
jedes Luftumlenkungsteil (22) ein Luftumlenkungsteil mit einer einstellbaren Länge ist; und ein Ende jedes Luftumlenkungsteils (22) mit dem Luftleitblech (21) verbunden ist und das andere Ende jedes Luftumlenkungsteils (22) mit einer Innenwand des Schrankkörpers (10) verbunden ist; oder
eine Führungsschiene (211) an einem Ende des Luftleitblechs (21) angeordnet ist, das der Vorrichtung (30) zugewandt ist, beide Seiten der Führungsschiene (211) mit einem Gleitschlitz für das Luftumlenkungsteil (22) versehen sind, um hinzudurchgehen, ein Ende des Luftumlenkungsteils (22) mit einer Innenwand des Schrankkörpers (10) verbunden ist, das andere Ende des Luftumlenkungsteils (22) durch einen der Gleitschlitze hindurchgeht und sich bis zu dem Ende des Luftleitblechs (21) erstreckt, das mit dem Schrankkörper (10) verbunden ist, und die Führungsschiene (211) auf dem Luftumlenkungsteil (22) gleitet, wenn das Luftleitblech (21) zusammengedrückt ist.

2. Schrank nach Anspruch 1, wobei jedes Luftumlenkungsteil (22) ein Luftumlenkungsteil mit einer einstellbaren Länge ist und aus einem elastischen Material hergestellt ist, so dass die Länge jedes Luftumlenkungsteils (22) einstellbar ist.

3. Schrank nach Anspruch 1, wobei jedes Luftumlenkungsteil (22) ein Luftumlenkungsteil mit einer einstellbaren Länge ist und aus mindestens zwei Luftumlenkungsplatten besteht, die miteinander gleitend verbunden sind, wobei ein Ende jedes Luftumlenkungsteils (22) mit dem Luftleitblech (21) drehbar verbunden ist und das andere Ende jedes Luftumlenkungsteils (22) mit der Innenwand des Schrankkörpers (10) verbunden ist.

4. Schrank nach Anspruch 3, wobei jedes Luftumlenkungsteil (22) eine erste Luftumlenkungsplatte und eine zweite Luftumlenkungsplatte umfasst, ein Ende der ersten Luftumlenkungsplatte mit dem Luftleitblech (21) drehbar verbunden ist, das andere Ende der ersten Luftumlenkungsplatte mit einem Ende der zweiten Luftumlenkungsplatte gleitend verbunden ist und das andere Ende der zweiten Luftumlenkungsplatte mit der Innenwand des Schrankkörpers (10) verbunden ist.

5. Schrank nach Anspruch 4, wobei jedes Luftumlenkungsteil (22) mit dem Luftleitblech (21) durch Verwenden einer Drehwelle, eines Gelenks oder eines flexiblen Materials drehbar verbunden ist.

6. Schrank nach einem der Ansprüche 1 bis 5, wobei das Luftleitblech (21) mindestens zwei Unterluftleitbleche (21a, 21b) umfasst und ein Raum zwischen zwei angrenzenden Unterluftleitblechen (21a, 21b) abgedichtet ist.

7. Schrank nach einem der Ansprüche 1 bis 6, wobei ein drehbarer Befestigungsabschnitt (221) an dem Ende jedes Luftumlenkungsteils (22) bereitgestellt ist, das mit der Innenwand des Schrankkörpers (10) verbunden ist, und der Befestigungsabschnitt (221) konfiguriert ist, um das Ende jedes Luftumlenkungsteils (22) mit dem Schrankkörper (10) zu verbinden.

8. Schrank nach Anspruch 7, wobei ferner mindestens zwei Montagestangen (40) in dem Schrankkörper (10) bereitgestellt sind und die Montagestangen (40) konfiguriert sind, um den Befestigungsabschnitt (221) mit dem Schrankkörper (10) zu verbinden.

9. Schrank nach einem der Ansprüche 1 bis 8, ferner umfassend eine Halterung (23), wobei das Luftleitblech (21) mit der Innenwand des Schrankkörpers (10) durch Verwenden der Halterung (23) verbunden ist.

## Revendications

1. Armoire, comprenant un corps d'armoire (10) et au moins un dispositif (30) disposé dans le corps d'armoire (10), dans laquelle
le corps d'armoire (10) est en outre pourvu d'au moins un système de conduit d'air (20), et le système de conduit d'air (20) comprend :
une pluralité de parties de déviation d'air (22) et un déflecteur d'air (21) qui est extensible le long d'une direction d'insertion du dispositif (30), dans laquelle une extrémité du déflecteur d'air (21) est reliée à une paroi intérieure du corps d'armoire (10), et l'autre extrémité du déflecteur d'air (21) s'appuie contre le dispositif (30) ; la pluralité de parties de déviation d'air (22) sont disposées le long du déflecteur d'air (21) dans le corps d'armoire (10), dans laquelle un intervalle existe entre deux parties de déviation d'air (22) adjacentes ; et lorsque le dispositif (30) est inséré dans un espacement, la pluralité de parties de déviation d'air (22) et le déflecteur d'air (21) divisent l'espace intérieur du corps d'armoire (10) en un conduit d'air froid (201) et un conduit d'air chaud (202) qui sont isolés l'un de l'autre, dans laquelle l'intervalle et l'espacement coïncident ;
dans laquelle un évent d'admission d'air du dispositif (30) et une paroi intérieure qui appartient au corps d'armoire (10) et sur laquelle est prévu un évent d'admission d'air sont tous deux situés dans le conduit d'air froid (201) ; un évent d'évacuation d'air du dispositif (30) et une paroi intérieure qui appartient au corps d'armoire (10) et sur laquelle est prévu un évent d'évacuation d'air sont tous deux situés dans le conduit d'air chaud (202) ; un côté de la pluralité de parties de déviation d'air (22), un côté du déflecteur d'air (21) et certaines parois intérieures du corps d'armoire (10) se rejoignent pour former le conduit d'air froid (201) ; et l'autre côté de la pluralité de parties de déviation d'air (22), l'autre côté du déflecteur d'air (21) et les parois intérieures restantes du corps d'armoire (10) se rejoignent pour former le conduit d'air chaud (202) ;
**caractérisée en ce que**
chaque partie de déviation d'air (22) est une partie de déviation d'air avec une longueur réglable ; et une extrémité de chaque partie de déviation d'air (22) est reliée au déflecteur d'air (21), et l'autre extrémité de chaque partie de déviation d'air (22) est reliée à une paroi intérieure du corps d'armoire (10) ; ou
un rail de guidage (211) est disposé à une extrémité du déflecteur d'air (21) qui fait face au dispositif (30), les deux côtés du rail de guidage (211) sont pourvus d'une fente coulissante à travers laquelle peut passer la partie de déviation d'air (22), une extrémité de la partie de déviation d'air (22) est reliée à une paroi intérieure du corps d'armoire (10), l'autre extrémité de la partie de déviation d'air (22) passe à travers l'une des fentes coulissantes et s'étend jusqu'à l'extrémité du déflecteur d'air (21) qui est reliée au corps d'armoire (10), et le rail de guidage (211) coulisse sur la partie de déviation d'air (22) lorsque le déflecteur d'air (21) est comprimé.

2. Armoire selon la revendication 1, dans laquelle chaque partie de déviation d'air (22) est une partie de déviation d'air avec une longueur réglable et est constituée d'un matériau élastique, de sorte que la longueur de chaque partie de déviation d'air (22) est réglable.

3. Armoire selon la revendication 1, dans laquelle chaque partie de déviation d'air (22) est une partie de déviation d'air avec une longueur réglable et se compose d'au moins deux panneaux de déviation d'air qui sont reliés de manière coulissante l'un à l'autre, une extrémité de chaque partie de déviation d'air (22) est reliée de manière rotative au déflecteur d'air (21), et l'autre extrémité de chaque partie de déviation d'air (22) est reliée à la paroi intérieure du corps d'armoire (10).

4. Armoire selon la revendication 3, dans laquelle chaque partie de déviation d'air (22) comprend un premier panneau de déviation d'air et un second panneau de déviation d'air, une extrémité du premier panneau de déviation d'air est reliée de manière rotative au déflecteur d'air (21), l'autre extrémité du premier panneau de déviation d'air est reliée de manière coulissante à une extrémité du second panneau de déviation d'air, et l'autre extrémité du second panneau de déviation d'air est reliée à la paroi intérieure du corps d'armoire (10).

5. Armoire selon la revendication 4, dans laquelle chaque partie de déviation d'air (22) est reliée de manière rotative au déflecteur d'air (21) à l'aide d'un arbre rotatif, d'une charnière ou d'un matériau flexible.

6. Armoire selon l'une quelconque des revendications 1 à 5, dans laquelle le déflecteur d'air (21) comprend au moins deux sous-déflecteurs d'air (21a, 21b), et l'espace entre deux sous-déflecteurs d'air (21a, 21b) adjacents est scellé.

7. Armoire selon l'une quelconque des revendications 1 à 6, dans laquelle une section de fixation (221) rotative est prévue à l'extrémité de chaque partie de déviation d'air (22) qui est reliée à la paroi intérieure du corps d'armoire (10), et la section de fixation (221) est conçue pour relier l'extrémité de chaque partie de déviation d'air (22) au corps d'armoire (10).

8. Armoire selon la revendication 7, dans laquelle au moins deux barres de montage (40) sont en outre prévues dans le corps d'armoire (10), et les barres de montage (40) sont conçues pour relier la section de fixation (221) au corps d'armoire (10).

9. Armoire selon l'une quelconque des revendications 1 à 8, comprenant en outre un support (23), dans laquelle le déflecteur d'air (21) est relié à la paroi intérieure du corps d'armoire (10) à l'aide du support (23).
